(19) Europäisches Patentamt
European Patent Office
Office européen des brevets

(11) EP 4 746 645 A1

(12) EUROPEAN PATENT APPLICATION
published in accordance with Art. 153(4) EPC

(43) Date of publication:
20.05.2026 Bulletin 2026/21

(21) Application number: 24845589.1

(22) Date of filing: 22.07.2024

(51) International Patent Classification (IPC):
$H10H\ 20/812^{(2025.01)}$  $H10H\ 20/816^{(2025.01)}$
$H10H\ 20/825^{(2025.01)}$  $H01S\ 5/343^{(2006.01)}$

(52) Cooperative Patent Classification (CPC):
H01S 5/343

(86) International application number:
PCT/JP2024/026161

(87) International publication number:
WO 2025/023213 (30.01.2025 Gazette 2025/05)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 25.07.2023 JP 2023120668

(71) Applicants:
• RIKEN
Wako-shi, Saitama 351-0198 (JP)

• Beam Technologies Inc.
Tokyo 102-0084 (JP)

(72) Inventors:
• JO, Masafumi
Wako-shi, Saitama 351-0198 (JP)
• IIMURA, Kazuki
Tokyo 102-0084 (JP)

(74) Representative: Buzzi, Notaro & Antonielli d'Oulx
S.p.A.
Corso Vittorio Emanuele II, 6
10123 Torino (IT)

(54) LED AND LED MANUFACTURING METHOD

(57) Provided is an LED which has a quantum well structure, including: a quantum well layer which has a composition of AlaGa1-aN (aluminum gallium nitride) (0 < a < 1); and a high level layer which has a composition of $Al_bGa_{1-b}N$ (a < b ≤ 1), is adjacent to the quantum well layer, and has a higher energy level than that of the quantum well layer, in which ΔX, which is a difference between the a and the b, and a width D (nm) of the quantum well layer satisfy (Relational Expression 1) D = k/ΔX (where, in Relational Expression 1, D > 3, 0 < ΔX < 0.15, and 0.45 ≤ k ≤ 1.25 (a unit of coefficient k is (nm))).

FIG.22

EP 4 746 645 A1

## EP 4 746 645 A1

**Description**

TECHNICAL FIELD

The present invention relates to an LED and an LED manufacturing method.

BACKGROUND ART

Patent Literature 1 describes "the quantum well structure 35 is a stack structure in which a plurality of well layers having a thickness of about 5 nm to about 50 nm and a barrier layer having a larger bandgap energy than that of the well layers are combined." (paragraph 0034) and "the fabricated LED includes a layered film of a homoepitaxial AlN layer (about 200 nm thick), a layer of n-$Al_{0.75}Ga_{0.25}N$ for the n-type electrical contact layer 30, an AlGaN/AlGaN multiple quantum well active region 35 (including four i-$Al_{0.6}Ga_{0.4}N$ layers), a p-$Al_{0.90}Ga_{0.10}N$ electron blocking layer (not illustrated), a p-type AlGaN cladding layer 42 (about 10 nm thick), and a p-type GaN electrical contact layer 45 (about 200 nm thick)." (paragraph 0048). Non-Patent Document 1 describes that "We obtained efficient PL emission of 234 and 245 nm from AlN/$Al_{0.18}Ga_{0.82}N$ and $Al_{0.8}Ga_{0.2}N$/$Al_{0.18}Ga_{0.82}N$ MQWs, respectively, at 77 K. The optimum value of well thickness was approximately 1.5 nm." (Machine translation: We obtained efficient PL emission of 234 and 245 nm from AlN/$Al_{0.18}Ga_{0.82}N$ and $Al_{0.8}Ga_{0.2}N$/$Al_{0.18}Ga_{0.82}N$ MQWs, respectively, at 77 K. The optimum value of well thickness was approximately 1.5 nm.) (abstract).

RELATED ART DOCUMENTS

PATENT DOCUMENT

Patent Document 1: Japanese translation publication of a PCT route patent application No. 2016-511938
Non-Patent Document 1: (Optical Properties of AlGaN Quantum Well Structures), Hideki Hirayama, Yasushi Enomoto, Atsuhiro Kinoshita, Akira Hirata&Yoshinobu Aoyagi, MRS Internet Journal of Nitride Semiconductor Research volume 5, pages 696-702 (2000)

GENERAL DISCLOSURE

In a first aspect of the present invention, provided is an LED which has a quantum well structure. The LED includes: a quantum well layer which has a composition of $Al_aGa_{1-a}N$ (aluminum gallium nitride) (0 < a < 1); and a high level layer which has a composition of $Al_bGa_{1-b}N$ (a < b ≤ 1), is adjacent to the quantum well layer, and has a higher energy level than that of the quantum well layer, and $\Delta X$, which is a difference between the a and the b, and a width D (nm) of the quantum well layer satisfy following Relational Expression 1:

$$(\text{Relational Expression 1}) \ D = k/\Delta X$$

(where, in Relational Expression 1, D > 3, 0 < $\Delta X$ < 0.15, and 0.45 ≤ k ≤ 1.25 (a unit of coefficient k is (nm))).
In the above LED, the D may be a smallest value in a range of the D in which an energy difference between a valence band potential or a conduction band potential of a polarization electric field existing in the quantum well layer and a quasi-Fermi level of carriers existing in the quantum well layer is 0.
In any of the above LEDs, the D may be a smallest value in a range of the D in which an energy difference between the valence band potential and a quasi-Fermi level of holes existing in the quantum well layer is 0.
In a second aspect of the present invention, provided is an LED which has a quantum well structure. The LED includes: a quantum well layer which has a composition of $In_{1-c}Ga_cN$ (indium gallium nitride) (0 < c < 1); and a high level layer which has a composition of $In_{1-d}Ga_dN$ (c < d ≤ 1), is adjacent to the quantum well layer, and has a higher energy level than that of the quantum well layer, and $\Delta X$, which is a difference between the c and the d, and a width D (nm) of the quantum well layer satisfy following Relational Expression 2:

$$(\text{Relational Expression 2}) \ D = k/\Delta X$$

(where, in Relational Expression 2, D ≥ 2, 0 < $\Delta X$ ≤ 0.15, and 0.30.3 ≤ k ≤ 0.60.6 (a unit of coefficient k is (nm))).
In the above LED, the D may be a smallest value in a range of the D in which an energy difference between a valence band potential or a conduction band potential of a polarization electric field existing in the quantum well layer and a quasi-Fermi level of carriers existing in the quantum well layer is 0.

In any of the above LEDs, the D may be a smallest value in a range of the D in which an energy difference between the valence band potential and a quasi-Fermi level of holes existing in the quantum well layer is 0.

In a third aspect of the present invention, provided is an LED manufacturing method for an LED which has a quantum well structure. The LED manufacturing method includes: forming a quantum well layer which has a composition of $Al_aGa_{1-a}N$ (aluminum gallium nitride) ($0 < a < 1$); and forming a high level layer which has a composition of $Al_bGa_{1-b}N$ ($a < b \leq 1$), is adjacent to the quantum well layer, and has a higher energy level than that of the quantum well layer, and $\Delta X$, which is a difference between the a and the b, and a width D (nm) of the quantum well layer satisfy following Relational Expression 1:

$$\text{(Relational Expression 1)} \quad D = k/\Delta X$$

(where, in Relational Expression 1, D > 3, $0 < \Delta X < 0.15$, and $0.45 \leq k \leq 1.25$ (a unit of coefficient k is (nm))).

In a fourth aspect of the present invention, provided is an LED manufacturing method for an LED which has a quantum well structure. The LED manufacturing method includes: forming a quantum well layer which has a composition of $In_{1-c}Ga_cN$ (indium gallium nitride) ($0 < c < 1$); and forming a high level layer which has a composition of $In_{1-d}Ga_dN$ ($c < d \leq 1$), is adjacent to the quantum well layer, and has a higher energy level than that of the quantum well layer, and $\Delta X$, which is a difference between the c and the d, and a width D (nm) of the quantum well layer satisfy following Relational Expression 2:

$$\text{(Relational Expression 2)} \quad D = k/\Delta X$$

(where, in Relational Expression 2, $D \geq 2$, $0 < \Delta X \leq 0.15$, and $0.3 \leq k \leq 0.6$ (a unit of coefficient k is (nm))).

Note that the summary clause does not necessarily describe all necessary features of the embodiments of the present invention. The present invention may also be a sub-combination of the features described above.

BRIEF DESCRIPTION OF THE DRAWINGS

Fig. 1 is a schematic view schematically illustrating an example of a structure of an LED 100 according to a first embodiment.

Fig. 2 is a diagram illustrating an example of a position in a Z axis direction and an Al composition X of each layer of the LED 100 according to the first embodiment.

Fig. 3 is a table illustrating a first simulation example of the Al composition X, a film thickness, and the like of each layer of the LED 100 according to the first embodiment.

Fig. 4 is a graph illustrating an example of a relationship between an Al composition of a high level layer and an emission wavelength of the LED 100 according to the first embodiment.

Fig. 5 is a graph illustrating a simulation result of a relationship between the width (D) of a quantum well layer 110 and emission efficiency (IQE) according to the first simulation example of Fig. 3.

Fig. 6 is a graph illustrating a relationship between an Al composition difference ($\Delta X$) between the high level layer and the quantum well layer 110 and the width (D) of the quantum well layer 110 where the emission efficiency reaches its local maximum for each Al composition difference ($\Delta X$).

Fig. 7 is a table illustrating a second simulation example of the Al composition X, the film thickness, and the like of each layer of the LED 100 according to the first embodiment.

Fig. 8 is a graph illustrating an example of a relationship between an Al composition X(a) of the quantum well layer **110** and the emission wavelength of the LED 100 according to the first embodiment.

Fig. 9 is a graph illustrating a simulation result of the relationship between the width (D) of the quantum well layer 110 and the emission efficiency (IQE) according to a second simulation example of Fig. 7.

Fig. 10 is a graph illustrating a relationship between the Al composition difference ($\Delta$X) in Fig. 9 and the width (D) of the quantum well layer 110 where the emission efficiency reaches its local maximum for each Al composition difference ($\Delta$X).

Fig. 11 is a diagram illustrating an example of a graph of an energy band and graph of respective wave functions of electrons and holes when the width D of the quantum well layer 110 is 3 nm in the LED 100 according to the first embodiment.

Fig. 12 is a diagram illustrating an example of the graph of the energy band and the graphs of the respective wave functions of electrons and holes when the width D of the quantum well layer 110 is 30 nm in the LED 100 according to the first embodiment.

Fig. 13 is a diagram illustrating an example of a graph of a conduction band potential, the graph of the wave function of electrons, and a graph of a quasi-Fermi level of electrons in the LED 100 according to the first embodiment.

Fig. 14 is a diagram illustrating an example of a graph of a valence band potential, the graph of the wave function of holes, and a graph of a quasi-Fermi level of holes in the LED 100 according to the first embodiment.

Fig. 15 is a table illustrating an example of a magnitude of a polarization electric field of the quantum well layer 110 in the LED 100 according to the first embodiment.

Fig. 16 is a diagram illustrating an example of a relationship between the width D of the quantum well layer 110 and the graph of the valence band potential in the LED 100 according to the first embodiment.

Fig. 17 is a diagram illustrating an example of an energy difference G between an energy level of holes and the quasi-Fermi level of holes when the Al composition difference $\Delta$X between the high level layer and the quantum well layer is 0.10 and the width D of the quantum well layer is 3 nm in an LED according to a comparative example.

Fig. 18 is a diagram illustrating an example of the energy difference G between the energy level of holes and the quasi-Fermi level of holes when the Al composition difference $\Delta$X between the high level layer and the quantum well layer 110 is 0.10 and the width D of the quantum well layer 110 is 5 nm in the LED 100 according to the first embodiment.

Fig. 19 is a table illustrating a simulation example of the Al composition and the film thickness when the Al composition of each layer is uniformly changed by +$\alpha$ in the LED 100 according to the first embodiment.

Fig. 20 is a graph illustrating simulation results of transition of the graph of the quasi-Fermi level of holes and the graph of the valence band potential when the Al composition of each layer is uniformly changed by +$\alpha$ according to the simulation example of Fig. 19.

Fig. 21 is a graph illustrating a relationship between each $\alpha$ in Fig. 20 and an energy difference $\Delta$E.

Fig. 22 is a graph illustrating a simulation example of the relationship between the Al composition difference ($\Delta$X) between the high level layer and the quantum well layer 110 and the width (D) of the quantum well layer 110, which changes according to an influence of an interface between the high level layer and the quantum well layer 110, in the LED 100 according to the first embodiment.

Fig. 23 is a schematic view schematically illustrating an example of a structure of an LED 200 according to a second embodiment.

Fig. 24 is a diagram illustrating an example of the position in the Z axis direction and a Ga composition X of each layer of the LED 200 according to the second embodiment.

Fig. 25 is a table illustrating a simulation example of the Ga composition X, a film thickness, and the like of each layer of the LED 200 according to the second embodiment.

Fig. 26 is a graph illustrating a simulation result of a relationship between a width (D) of a quantum well layer 210 and the emission efficiency (IQE) according to the simulation example of Fig. 25.

Fig. 27 is a graph illustrating a relationship between a Ga composition difference ($\Delta X$) in Fig. 26 and the width (D) of the quantum well layer 210 where the emission efficiency reaches its local maximum for each Ga composition difference ($\Delta X$).

Fig. 28 is a table illustrating an example of the magnitude of the polarization electric field of the quantum well layer 210 in the LED 200 according to the second embodiment.

Fig. 29 is a graph illustrating a simulation example of the relationship between the Al composition difference ($\Delta X$) between the high level layer and the quantum well layer 210 and the width (D) of the quantum well layer 210 when a strain state of the quantum well layer 210 is coherent strain in the LED 200 according to the second embodiment.

Fig. 30 is a graph illustrating a simulation example of the relationship between the Al composition difference ($\Delta X$) between the high level layer and the quantum well layer 110 and the width (D) of the quantum well layer 110 when the quantum well layer 110 of the LED 100 according to the first embodiment is a three-layer multiple quantum well layer (MQW layer) in which a strain state is coherent strain.

Fig. 31 is a diagram illustrating another example of the position in the Z axis direction of each layer and the Al composition X of the LED 100 according to the first embodiment.

Fig. 32 is a table illustrating an experimental example of the Al composition X, the film thickness, and the like of each layer of the LED 100 according to the first embodiment.

Fig. 33 is a graph illustrating experimental results of a relationship among the width (D) of the quantum well layer 110, the emission wavelength, and an intensity according to the experimental example of Fig. 32.

DESCRIPTION OF EXEMPLARY EMBODIMENTS

The present invention will be described below through embodiments of the invention, but the following embodiments do not limit the invention according to the claims. Further, not all of combinations of features described in the embodiments are essential to the solving means of the invention.

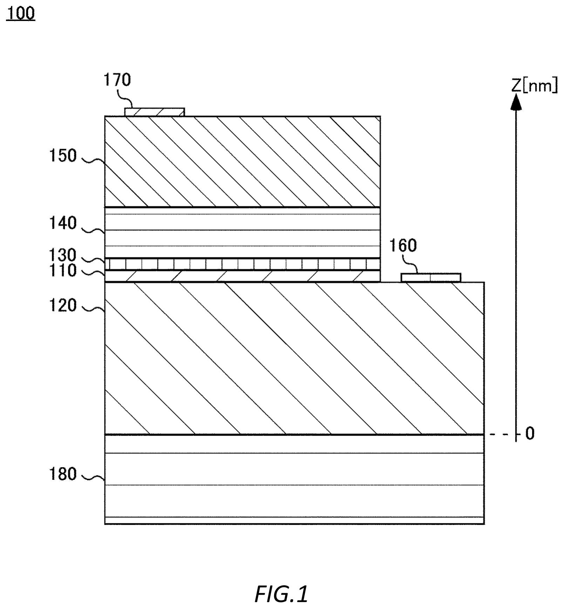

Fig. 1 is a schematic view schematically illustrating an example of a structure of an LED 100 according to a first embodiment. An LED described in the present application is an LED having a quantum well structure that increases internal quantum efficiency (IQE, emission efficiency), and is formed by stacking a plurality of layers on a substrate. More specifically, the LED 100 according to the first embodiment includes a quantum well layer 110, an N-type contact layer 120, an electron blocking layer 130, a P-type cap layer 140, a P-type contact layer 150, an N-layer electrode 160, a P-layer electrode 170, and a substrate 180.

The LED 100 may also be referred to as an ultraviolet LED, an ultraviolet light emitting diode, a deep ultraviolet LED, a deep ultraviolet light emitting diode, or the like. As an example, the LED 100 is a back-side emission type LED, and emits light from a back surface of the substrate 180 at a lowermost portion. As illustrated in Fig. 1, a stacking direction of the LEDs 100 is defined as a Z axis direction, a position of a surface of the substrate 180, that is, a position of one end surface of the N-type contact layer 120 on a substrate 180 side is defined as Z = 0 (nm), and a direction from the one end surface toward another end surface of the N-type contact layer 120 is defined as a positive Z axis direction. In following description, a length in the Z axis direction of an arbitrary layer included in the LED 100 may be referred to as a width or a film thickness. The same applies to a plurality of following embodiments, and redundant description will be omitted.

The quantum well layer 110 may also be referred to as a light emitting layer, a quantum well (QW) layer, a multiple QW (MQW) layer, an active layer, or the like, and is a layer in which electrons and holes recombine to generate light. The quantum well layer 110 recombines electrons and holes by spatially confining electrons and holes. As an example, the quantum well layer 110 has a composition of $Al_aGa_{1-a}N$ (aluminum gallium nitride) ($0 < a < 1$). As an example, the quantum well layer 110 is a single quantum well layer (QW layer). Note that in following description, subscripts indicating contents, such as "a" and "b", may be omitted, and expressions such as "AlGaN", "InGaN", and "AlInGaN" may be used as abbreviations or generic terms.

The N-type contact layer 120 is a layer adjacent to a negative Z axis side of the quantum well layer 110. The N-type contact layer 120 may also be referred to as an N-type semiconductor layer, an N-layer, or the like, and is a layer that supplies electrons to the quantum well layer 110. As an example, the N-type contact layer 120 has a composition of n-$Al_{b1}Ga_{1-b1}N$ ($a < b1 \leq 1$) doped with at least one type of impurity, for example, Si. The N-type contact layer 120 has a higher energy level than that of the quantum well layer 110. The N-type contact layer 120 is an example of a high level layer described later. Note that the LED 100 may additionally include a barrier layer having a higher energy level than that of the N-type contact layer 120 between the N-type contact layer 120 and the quantum well layer 110, and in this case, the barrier layer is an example of the high level layer. Note that the barrier layer and the quantum well layer 110 may be collectively referred to as a light emitting layer.

The electron blocking layer 130 is a layer adjacent to a positive Z axis side of the quantum well layer 110. The electron blocking layer 130 may also be referred to as an EBL, an electron barrier layer, or the like, and is a layer that prevents leakage (overflow) of electrons from the quantum well layer 110. As an example, the electron blocking layer 130 has a composition of $Al_{b2}Ga_{1-b2}N$ ($a < b2 \leq 1$). As an example, the electron blocking layer 130 may be doped with one or more impurities such as Mg. The electron blocking layer 130 has a higher energy level than that of the quantum well layer 110. The electron blocking layer 130 is an example of the high level layer.

The P-type cap layer 140 is a layer adjacent to a positive Z axis side of the electron blocking layer 130. The P-type cap layer 140 may also be referred to as a P-type semiconductor layer, a P-layer, or the like, and is a layer that supplies holes to the quantum well layer 110. As an example, the P-type cap layer 140 has a composition of $p-Al_{b3}Ga_{1-b3}N$ ($a < b3 \leq 1$) doped with at least one type of impurity, for example, Mg. Note that the LED 100 may not include the electron blocking layer 130, and in this case, the P-type cap layer 140 is an example of the high level layer adjacent to the quantum well layer 110 and having a higher energy level than that of the quantum well layer 110.

The P-type contact layer 150 is a layer adjacent to a positive Z axis side of the P-type cap layer 140. The P-type contact layer 150 may also be referred to as a P-type semiconductor layer, a P-layer, or the like, and is a layer that supplies holes to the quantum well layer 110, similarly to the P-type cap layer 140. As an example, the P-type contact layer 150 has a composition of p-GaN doped with at least one type of impurity, for example, Mg.

The N-layer electrode 160 is provided on a positive Z axis side of the N-type contact layer 120, and is electrically connected to the N-type contact layer 120. The N-layer electrode 160 is formed of an ohmic metal material such as Ni or Au, for example. The P-layer electrode 170 is provided on a positive Z axis side of the P-type contact layer 150, and is electrically connected to the P-type contact layer 150. Similarly to the N-layer electrode 160, the P-layer electrode 170 is formed of an ohmic metal material such as Ni or Au, for example. Note that the LED 100 may not include the P-type contact layer 150, and in this case, the P-layer electrode 170 is provided on the positive Z axis side of the P-type cap layer 140 and is electrically connected to the P-type cap layer 140. As an example, the substrate 180 is a sapphire substrate.

An object of the LED 100 according to the first embodiment is to set a width D of the quantum well layer 110 so as to increase the IQE of the LED 100 as much as possible when at least the width D can be freely set while at least one of an emission wavelength of the LED 100, Al compositions of the quantum well layer 110 and the high level layer, or an Al composition difference therebetween is determined in advance.

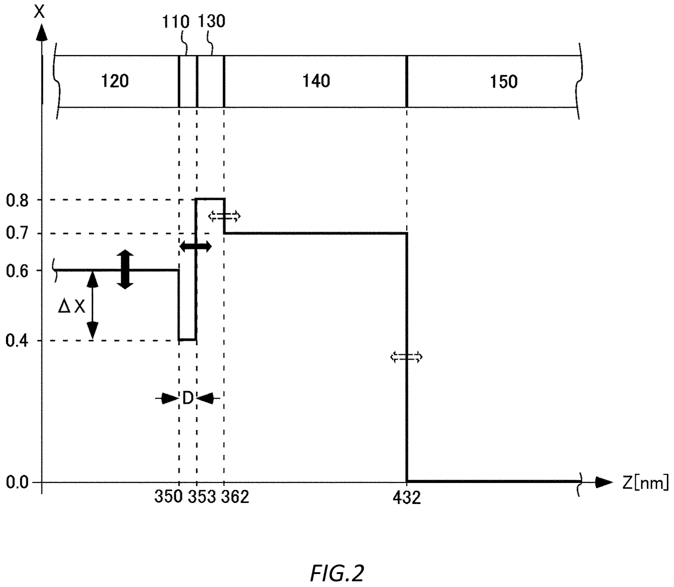

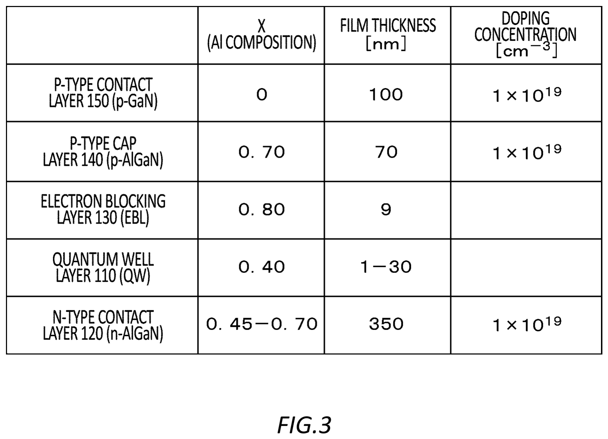

Fig. 2 is a diagram illustrating an example of a position in the Z axis direction and an Al composition X of each layer of the LED 100 according to the first embodiment. Fig. 3 is a table illustrating a first simulation example of the Al composition X, a film thickness, and the like of each layer of the LED 100 according to the first embodiment.

A horizontal axis illustrated in Fig. 2 represents a position Z (nm) in the Z axis direction, and a vertical axis represents the Al composition X defined in a range of 0 to 1 (0% to 100%). In the present embodiment, "X" is a generic term for "a", "b1", "b2", and "b3" described above and "b" described later. In Fig. 2, the Al composition X in each layer of the LED 100 is shown by one continuous thick-line graph. Further, in Fig. 2, the layers existing at respective positions Z are shown in a band graph shape on an upper side of the graph.

A first row of the table of Fig. 3 shows the X (Al composition), the film thickness (nm), and a doping concentration ($cm^{-3}$) in order from a left side. A second row to a fifth row of the table of Fig. 3 show, in order, the Al compositions X, the film thicknesses, and the like of the P-type contact layer 150 (p-GaN), the P-type cap layer 140 (p-AlGaN), the electron blocking layer 130 (EBL), the quantum well layer 110 (QW), and the N-type contact layer 120 (n-AlGaN).

In the first simulation example illustrated in Fig. 3, the Al composition X, the film thickness, and the doping concentration of the P-type contact layer 150 are set to 0, 100 (nm), and $1 \times 10^{19}$ ($cm^{-3}$). The Al composition X(b3), the film thickness, and the doping concentration of the P-type cap layer 140 are set to 0.70, 70 (nm), and $1 \times 10^{19}$ ($cm^{-3}$). The Al composition X(b2) and the film thickness of the electron blocking layer 130 are set to 0.80 and 9 (nm).

In the first simulation example illustrated in Fig. 3, the Al composition X(b1) of the N-type contact layer 120 is changed from 0.45 to 0.70 by 0.025 or 0.05. The film thickness and the doping concentration of the N-type contact layer 120 are set to 350 (nm) and $1 \times 10^{19}$ ($cm^{-3}$). In the first simulation example, the film thickness, that is, the width of the quantum well layer 110 is changed in a range of 1 to 30 (nm) in each Al composition X(b1) of the N-type contact layer 120. The Al composition X(a) of the quantum well layer 110 is set to 0.40. Note that when the Al composition X(a) of the quantum well layer 110 is 0.40, the emission wavelength of the LED 100 is set to about 280 to 300 nm. Note that it is known that when the Al composition X(b1) of the N-type contact layer 120 is excessively large, for example, higher than 0.9, an electric resistance of the N-type contact layer 120 increases and electrons hardly flow, and on the other hand, when the Al composition X(b1) of the N-type contact layer 120 is excessively small, for example, the same as the Al composition X(a) of the quantum well layer 110, confinement of electrons in the quantum well layer 110 becomes shallow and the emission efficiency decreases.

In the graph of Fig. 2, a mode of varying the Al composition X(b1) of the N-type contact layer 120 corresponding to the first simulation example of Fig. 3 is indicated by a black arrow. Also, on the graph, the width of the quantum well layer 110 is indicated by D, and a mode of varying the width D, that is, varying the position Z of the surface of the quantum well layer 110 corresponding to the first simulation example of Fig. 3 is indicated by a black arrow. Also, on the graph, a variation mode of the position Z of each surface of the electron blocking layer 130 and the P-type cap layer 140 according to the variation of the width D is indicated by a white arrow. Also, on the graph, an Al composition difference between the N-type contact layer 120 as an example of the high level layer and the quantum well layer 110 is indicated by $\Delta X$ (= b1 - a). Each of the above definitions related to Fig. 2 is similar in following drawings similar to Fig. 2, and redundant description is omitted.

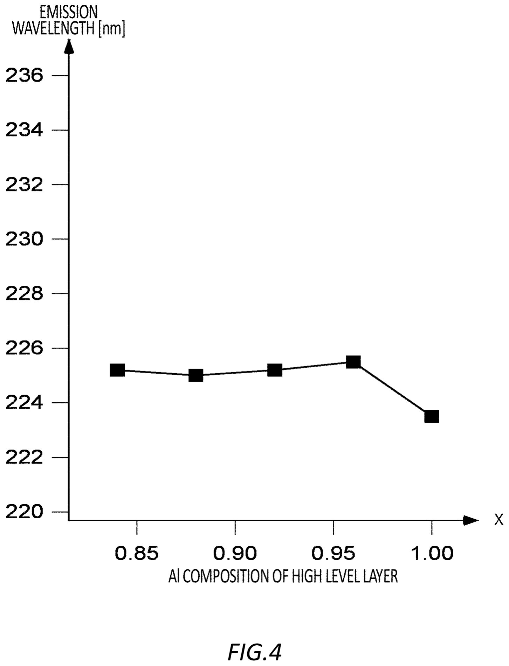

Fig. 4 is a graph illustrating an example of a relationship between the Al composition of the high level layer and the emission wavelength of the LED 100 according to the first embodiment. In Fig. 4, a horizontal axis represents the Al composition X of the high level layer, and a vertical axis represents the emission wavelength (nm) of the LED 100.

As described above, the high level layer has a composition of $Al_bGa_{1-b}N$ (a < b ≤ 1), is adjacent to the quantum well layer 110, and has a higher energy level than that of the quantum well layer 110. In a case of a configuration of the LED 100 illustrated in Fig. 1, the high level layer may refer to both the N-type contact layer 120 and the electron blocking layer 130, or may refer to one of these. In addition, in the first embodiment, description "Al composition b of the high level layer" may refer to an average of an Al composition b1 of the N-type contact layer 120 and an Al composition b2 of the electron blocking layer 130, or may refer to the Al composition of any one of these. $\Delta X$ refers to the Al composition difference (b - a) between the Al composition b of the high level layer and an Al composition a of the quantum well layer 110. In following description of a plurality of embodiments, only the N-type contact layer 120 is referred to as the high level layer in order to simply clarify the description.

As illustrated in Fig. 4, it is understood that the emission wavelength of the LED 100 hardly changes even when the Al composition X(b1) of the N-type contact layer 120 which is the high level layer is varied.

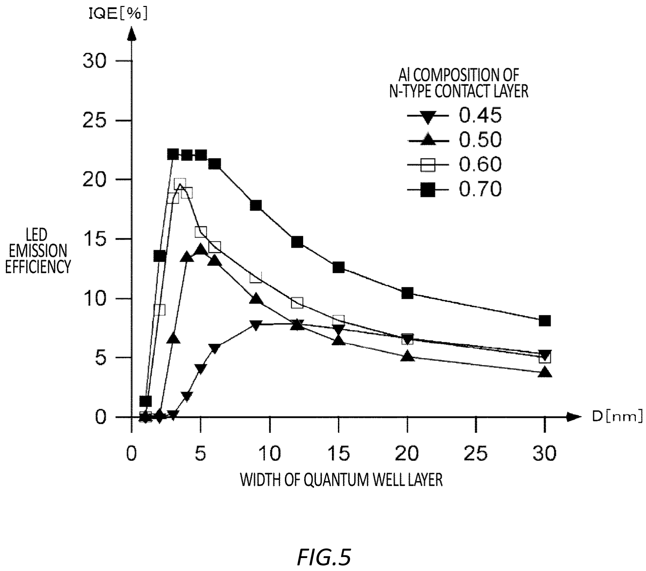

Fig. 5 is a graph illustrating a simulation result of a relationship between the width (D) of the quantum well layer 110 and the emission efficiency (IQE) according to the first simulation example of Fig. 3. In Fig. 5, a horizontal axis represents the width D (nm) of the quantum well layer 110, and a vertical axis represents the emission efficiency (IQE) (%) of the LED 100.

In this simulation, it is assumed that an operating current (J) of 10 (A/cm$^2$) flows through the LED 100. In this simulation, for a case where the Al composition X(b1) of the N-type contact layer 120 was set to each of 0.45, 0.50, 0.60, and 0.70, transition of the IQE of the LED 100 with a change in the width D of the quantum well layer 110 was confirmed. Fig. 5 illustrates a graph of the transition when the Al composition X(b1) of the N-type contact layer 120 was set to each of 0.45, 0.50, 0.60, and 0.70. Calculated values of the width D and the IQE are plotted on each graph. Note that as described with reference to Fig. 3, the width D was changed in the range of 1 to 30 (nm).

As illustrated in Fig. 5, it is understood that there exists the width D of the quantum well layer 110 that gives a local maximum value of the IQE of the LED 100, regardless of the Al composition X(b1) of the N-type contact layer 120.

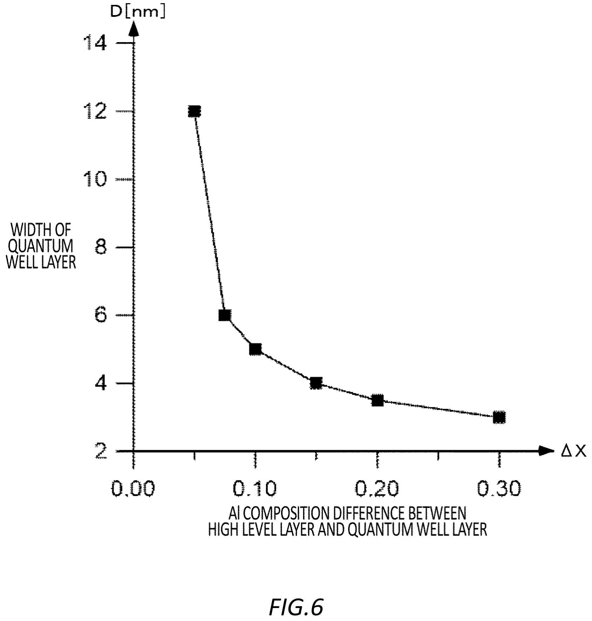

Fig. 6 is a graph illustrating a relationship between the Al composition difference ($\Delta X$) between the high level layer and the quantum well layer 110 and the width (D) of the quantum well layer 110 where the emission efficiency reaches its local maximum for each Al composition difference ($\Delta X$). In Fig. 6, a horizontal axis represents the Al composition difference $\Delta X$ (= b1 - a) between the high level layer, that is, the N-type contact layer 120 and the quantum well layer 110, and a vertical axis represents the width D (nm) of the quantum well layer 110.

As illustrated in Fig. 6, it is understood that, as the Al composition difference $\Delta X$ (= b - a) between the Al composition a of the quantum well layer 110 and the Al composition b of the high level layer decreases, the width D of the quantum well layer 110 that gives the local maximum value of the IQE of the LED 100 increases. In other words, it is understood that $\Delta X$ (= b - a), which is the difference between the Al composition a in the quantum well layer 110 and the Al composition b in the high level layer, and the width D (nm) of the quantum well layer 110 that gives the local maximum value of the IQE have a negative correlation. Specifically, as $\Delta X$ decreases, D that gives the local maximum of the IQE increases.

According to the graphs illustrated in Figs. 5 and 6, it is understood that when the Al composition difference $\Delta X$ between the Al composition of the quantum well layer 110 and the Al composition of the high level layer is small, that is, when confinement of electrons and the like in the quantum well layer 110 is shallow, a ratio of electrons and the like, which are desired to emit light within the quantum well layer 110, leaking to an outside becomes high, and thus the local maximum value of the IQE of the LED 100 becomes lower than when the Al composition difference $\Delta X$ is large. However, according to the LED 100 according to the present embodiment, even under any restriction other than the width D of the quantum well layer 110, for example, even when the emission wavelength of the LED 100 is determined in advance, that is, the Al composition of the quantum well layer 110 is determined in advance, and the Al composition difference $\Delta X$ is also determined in advance, the width D can be set to increase the IQE as much as possible. According to the LED 100, if the Al composition of the high level layer can be further increased, that is, if the Al composition difference $\Delta X$ can be increased, the IQE can be further increased by setting the width D to increase the IQE as much as possible while increasing the Al composition difference $\Delta X$.

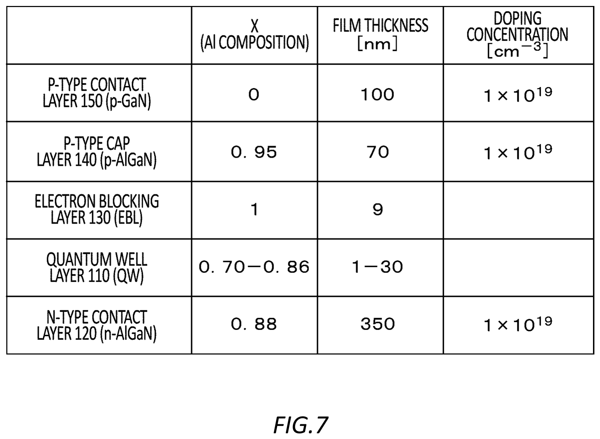

Fig. 7 is a table illustrating a second simulation example of the Al composition X, the film thickness, and the like of each layer of the LED 100 according to the first embodiment. Similarly to the table of Fig. 3, a first row of the table of Fig. 7 shows the X (Al composition), the film thickness (nm), and the doping concentration (cm$^{-3}$) in order from a left side. Similarly to the table of Fig. 3, the X, a second row to a fifth row of the table of Fig. 7 show, in order, the film thickness, and the like of the P-type contact layer 150 (p-GaN), the P-type cap layer 140 (p-AlGaN), the electron blocking layer 130 (EBL), the quantum well layer 110 (QW), and the N-type contact layer 120 (n-AlGaN).

In the second simulation example illustrated in Fig. 7, the Al composition X, the film thickness, and the doping concentration of the P-type contact layer 150 are set to 0, 100 (nm), and $1\times10^{19}$ (cm$^{-3}$). The Al composition X(b3), the film thickness, and the doping concentration of the P-type cap layer 140 are set to 0.95, 70 (nm), and $1\times10^{19}$ (cm$^{-3}$). The Al composition X(b2) and the film thickness of the electron blocking layer 130 are set to 1 and 9 (nm). The Al composition X(b1), the film thickness, and the doping concentration of the N-type contact layer 120 are set to 0.88, 350 (nm), and $1\times10^{19}$ (cm$^{-3}$).

In the second simulation example illustrated in Fig. 7, the Al composition X(a) of the quantum well layer 110 is changed by 0.04 from 0.70 to 0.86, more specifically, from 0.74 to 0.86. In the second simulation example, in each Al composition X(a) of the quantum well layer 110, the film thickness, that is, the width of the quantum well layer 110 is changed in the range of 1 to 30 (nm). Note that when the Al composition X(a) of the quantum well layer 110 is 0.70 to 0.86, the emission wavelength of the LED 100 is about 220 to 240 nm.

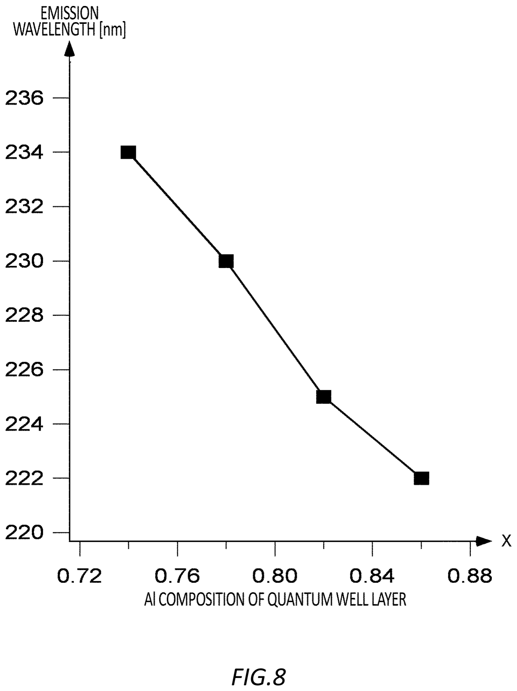

Fig. 8 is a graph illustrating an example of a relationship between the Al composition X(a) of the quantum well layer 110 and the emission wavelength of the LED 100 according to the first embodiment. In Fig. 8, a horizontal axis represents the Al composition X(a) of the quantum well layer 110, and a vertical axis represents the emission wavelength (nm) of the LED 100. As illustrated in Fig. 8, it is understood that the emission wavelength of the LED 100 changes by varying the Al composition X(a) of the quantum well layer 110.

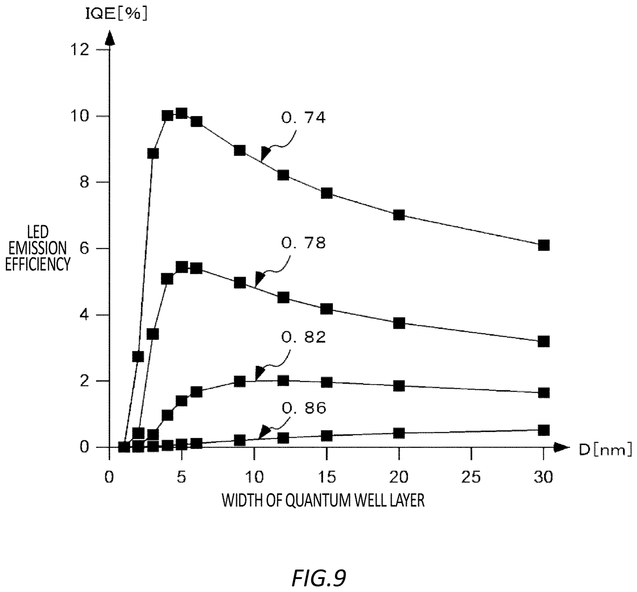

Fig. 9 is a graph illustrating a simulation result of the relationship between the width (D) of the quantum well layer 110 and the emission efficiency (IQE) according to the second simulation example of Fig. 7. In Fig. 9, a horizontal axis represents the width D (nm) of the quantum well layer 110, and a vertical axis represents the emission efficiency (IQE) (%) of the LED 100.

Also in this simulation, similarly to the first simulation, it is assumed that the operating current (J) of 10 (A/cm$^2$) flows through the LED 100. Fig. 9 illustrates a graph of the transition of the IQE of the LED 100 with the change in the width D of the quantum well layer 110 for a case where the Al composition X(a) of the quantum well layer 110 was set to each of 0.74, 0.78, 0.82, and 0.86. Calculated values of the width D and the IQE are plotted on each graph. Note that similarly to the first simulation, the width D was changed in the range of 1 to 30 (nm).

As illustrated in Fig. 9, it is understood that there exists the width D of the quantum well layer 110 that gives a local maximum value of the IQE of the LED 100, regardless of the Al composition X(a) of the quantum well layer 110. Note that, as a result of the second simulation example, it has been confirmed that, when the Al composition X(a) of the quantum well layer 110 is 0.86, the IQE reaches its local maximum when the width D of the quantum well layer 110 is 40 nm, and the IQE hardly decreases even when the width D is larger than 40 nm.

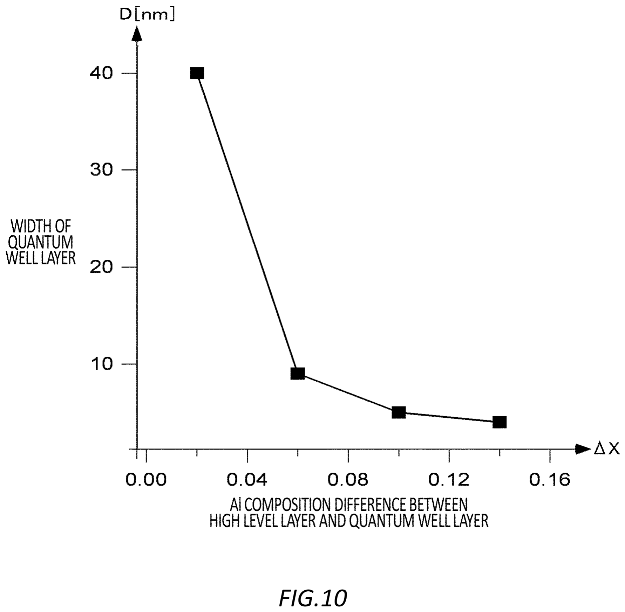

Fig. 10 is a graph illustrating a relationship between the Al composition difference ($\Delta$X) in Fig. 9 and the width (D) of the quantum well layer 110 where the emission efficiency reaches its local maximum for each Al composition difference ($\Delta$X). In Fig. 10, a horizontal axis represents the Al composition difference $\Delta$X (= b1 - a) between the high level layer, that is, the N-type contact layer 120 and the quantum well layer 110, and a vertical axis represents the width D (nm) of the quantum well layer 110.

Also in the second simulation example, a result similar to that in the first simulation example was obtained. Specifically, as illustrated in Fig. 10, it is understood that, as the Al composition difference $\Delta$X (= b - a) between the Al composition a of the quantum well layer 110 and the Al composition b of the high level layer decreases, the width D of the quantum well layer 110 that gives the local maximum value of the IQE of the LED 100 increases. In other words, it is understood that $\Delta$X (= b - a), which is the difference between the Al composition a in the quantum well layer 110 and the Al composition b in the high level layer, and the width D (nm) of the quantum well layer 110 that gives the local maximum value of the IQE have a negative correlation. Specifically, as $\Delta$X decreases, D that gives the local maximum of the IQE increases.

According to the graphs illustrated in Figs. 8 to 10, it is understood that, in order to make the emission wavelength of the LED 100 shorter, it is necessary to increase the Al composition of the quantum well layer 110, and when the Al composition of the quantum well layer 110 is increased, the Al composition difference $\Delta$X from the high level layer is reduced, so that confinement of electrons and holes in the quantum well layer 110 is weakened, and the local maximum value of IQE of the LED 100 is lowered. Therefore, when it is desired to make the emission wavelength of the LED 100 shorter, the width D of the quantum well layer 110 may be set to the width D that gives the local maximum value of the IQE of the LED 100, for example, based on the result of Fig. 10.

With respect to the plurality of simulations according to the first embodiment described with reference to Figs. 3 to 10, the inventors of the present application and the like have found following points as a result of earnest research.

The emission recombination in the quantum well layer 110 is proportional to (a sum of) a product of an electron concentration and a hole concentration in the quantum well layer 110. In other words, the emission efficiency IQE of the LED 100 corresponds to a probability that electrons and holes encounter each other in the quantum well layer 110, and thus is determined by the product of the concentrations of electrons and holes in the quantum well layer 110. A spatial distribution of a carrier (electron and hole) concentration in the quantum well layer 110 is determined by three of (1) a form (degree of spatial overlap) of a wave function at an energy level of carriers related to light emission, (2) a number of at least one energy level of carriers related to light emission, and (3) an energy difference between the energy level and the quasi-Fermi level of carriers related to light emission.

When the width D of the quantum well layer 110 is reduced, the spatial overlap of (1) is improved, and the probability that electrons and holes encounter each other is increased, but on the other hand, the number of (2) is reduced, and the energy difference of (3) is increased, so that the carrier concentration is reduced, and the probability that electrons and holes encounter each other is reduced. When the width D of the quantum well layer 110 is increased, the spatial overlap of (1) is deteriorated, and the probability that electrons and holes encounter each other is reduced, but on the other hand, the number of (2) is increased, and the energy difference of (3) is reduced, so that the carrier concentration is increased, and the probability that electrons and holes encounter each other is increased. However, when the width D of the quantum well layer 110 is made larger than a predetermined size, an increase in the carrier concentration due to (2) and (3) is eliminated, and the probability of encounter due to (1) only continues to decrease. In other words, by setting the width D of the quantum well layer 110 to the predetermined size, it is possible to cause the IQE of the LED 100 to reach its local maximum.

The energy difference of (3) depends not only on the width D of the quantum well layer 110 but also on a magnitude (eV/nm) of a polarization electric field existing in the quantum well layer 110, and the magnitude (eV/nm) of the polarization electric field depends on a magnitude of $\Delta X$, which is the difference between the Al composition in the quantum well layer 110 and the Al composition in the high level layer. Therefore, the width D of the quantum well layer 110 that gives the local maximum value of the IQE of the LED 100 can be determined based on $\Delta X$. For example, when the Al compositions of the quantum well layer 110 and the high level layer are determined in advance, that is, $\Delta X$ is determined in advance, the width D of the quantum well layer 110 that gives the local maximum value of the IQE of the LED 100 can be determined based on a magnitude of the $\Delta X$.

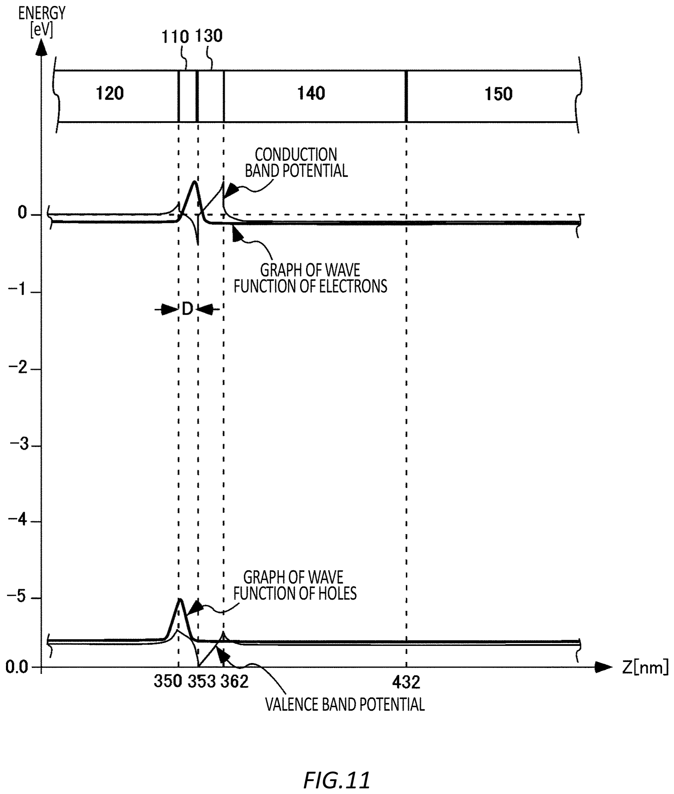

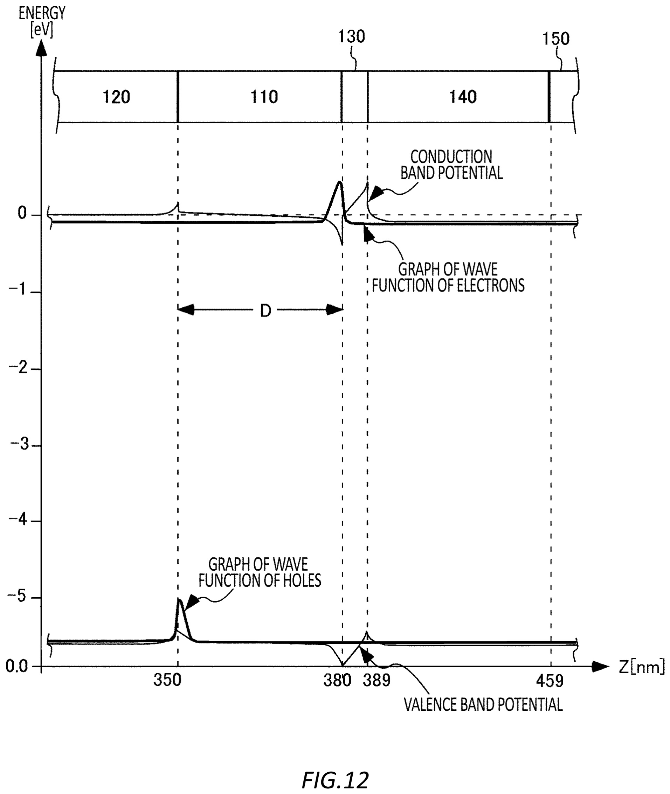

Here, the above (1) and (2) will be described with reference to Figs. 11 and 12. Fig. 11 is a diagram illustrating an example of a graph of an energy band and graphs of respective wave functions of electrons and holes when the width D of the quantum well layer 110 is 3 nm in the LED 100 according to the first embodiment. Fig. 12 is a diagram illustrating an example of the graph of the energy band and the graphs of the respective wave functions of electrons and holes when the width D of the quantum well layer 110 is 30 nm in the LED 100 according to the first embodiment. In Figs. 11 and 12, a horizontal axis represents the position Z (nm), and a vertical axis represents the energy (eV).

A polarization electric field exists in a semiconductor such as the quantum well layer 110 of the LED 100, and the polarization electric field is divided into a conduction band in which electrons exist and a valence band in which holes exist, with a band gap therebetween in which no carriers exist. Figs. 11 and 12 illustrate a graph of an energy level of a low energy side end portion in a conduction band potential and a graph of an energy level of a high energy side end portion in a valence band potential, respectively. The same applies to similar drawings described below, and redundant description will be omitted.

Since electrons existing in the conduction band of the quantum well layer 110 tend to move to a lower energy level side, they easily accumulate on the positive Z axis side of the quantum well layer 110 having a lowest conduction band potential. On the other hand, since holes existing in the valence band of the quantum well layer 110 tend to move to a higher energy level side, they easily accumulate on the negative Z axis side of the quantum well layer 110 having a highest valence band potential. Therefore, as an example, the form of the wave function at the energy level of carriers (electrons and holes) related to light emission, that is, a form of a graph of the wave function of carriers is as shown by a thick line in Fig. 11 when the width D of the quantum well layer 110 is as considerably small as about 3 nm, and is as shown by a thick line in Fig. 12 when the width D of the quantum well layer 110 is as considerably large as about 30 nm.

Comparing the respective graphs of the wave functions of the carriers in Figs. 11 and 12, it is understood that, when the width D of the quantum well layer 110 decreases, the spatial overlap between the wave function at the energy level of electrons related to light emission and the wave function at the energy level of holes related to light emission is improved (for example, there are many portions where distributions of both wave functions coincide with each other, and the positions Z of peaks in the graphs of both wave functions are close). However, it is also understood that when the width D of the quantum well layer 110 decreases, the width D of the quantum well layer 110 decreases, so that carrier confinement becomes shallow, and the number of at least one energy level of carriers related to light emission in the above (2) decreases (for example, leakage of carriers from the quantum well layer 110 to the N-type contact layer 120 or the electron blocking layer 130).

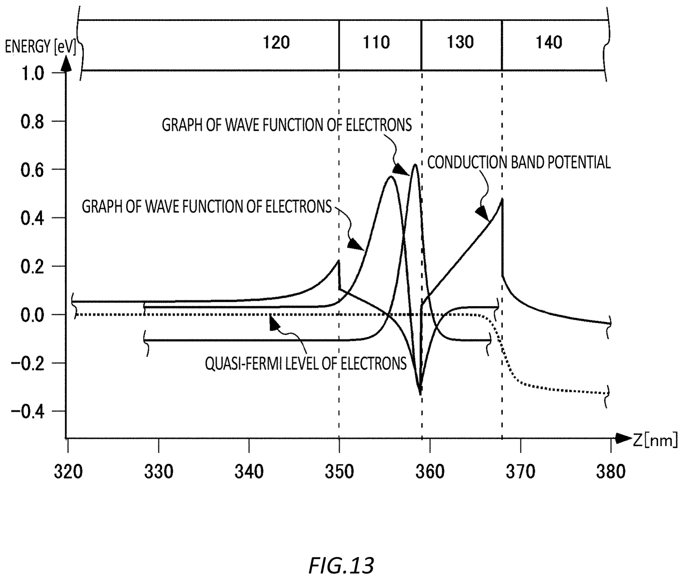

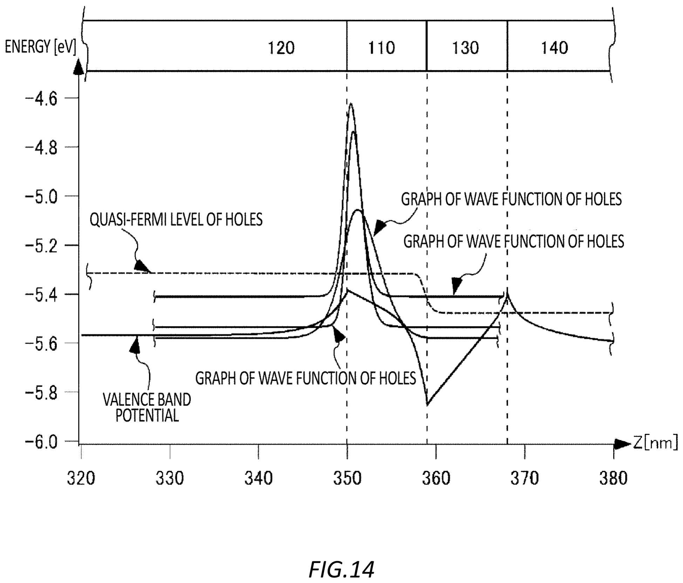

Next, the energy level and the quasi-Fermi level of carriers related to light emission in the above (3) will be described using Figs. 13 and 14. Fig. 13 is a diagram illustrating an example of a graph of the conduction band potential, the graph of the wave function of electrons, and a graph of a quasi-Fermi level of electrons in the LED 100 according to the first embodiment. Fig. 14 is a diagram illustrating an example of a graph of the valence band potential, the graph of the wave function of holes, and a graph of a quasi-Fermi level of holes in the LED 100 according to the first embodiment. In Figs. 13 and 14, a horizontal axis represents the position Z (nm), and a vertical axis represents the energy (eV). In Figs. 13 and 14, only the graph of the quasi-Fermi level of carriers is indicated by a curved broken line, and the same applies to subsequent drawings.

According to the graphs of the wave functions of electrons and holes illustrated in Figs. 13 and 14, as an example, there are two energy levels of electrons related to light emission and there are three energy levels of holes related to light emission. Correspondingly, two graphs of the wave functions of electrons are shown in Fig. 13, and three graphs of the wave functions of holes are shown in Fig. 14. By a product of these energy levels, six cross-terms emerge. A result obtained by evaluating, from a viewpoint of the above (3), how easily each of these six emits light and adding them all together can be an evaluation of an overall light emission. In following description, in order to simply clarify the description, the number of at least one energy level of carriers related to light emission, that is, a number of at least one graph of wave functions of the carriers is assumed to be only one.

The quasi-Fermi level of carriers may be an energy level at which the carrier concentration is 50% when the quantum well layer 110 of the LED 100 is in a non-thermal equilibrium state, for example, when the operating current (J) flows through the LED 100. In the above (3), the fact that the energy difference between the energy level and the quasi-Fermi level of carriers related to light emission is small may indicate that a concentration of carriers contributing to light emission among carriers confined in the quantum well layer 110 in the non-thermal equilibrium state is high.

In general, in a nitride semiconductor, an N-type semiconductor is easy to achieve, and a P-type semiconductor is difficult to achieve, that is, it is easy to supply electrons, and it is difficult to supply holes. Therefore, in the quantum well layer 110 having a composition of $Al_aGa_{1-a}N$ (0 < a < 1), it is easy to obtain a high electron concentration, and a position of the quasi-Fermi level of electrons does not become a significant problem. That is, the quasi-Fermi level of electrons is at such a position that ab energy difference (distance) from the conduction band potential does not cause a problem. On the other hand, in the quantum well layer 110 having a composition of $Al_aGa_{1-a}N$ (0 < a < 1), it is difficult to obtain a high hole concentration, and the quasi-Fermi level of holes is at a position that an energy difference from the valence band potential can cause a problem. Therefore, in the above (3), holes become a more dominant factor than electrons. In this regard, in following description regarding the above (1) to (3), holes will be considered.

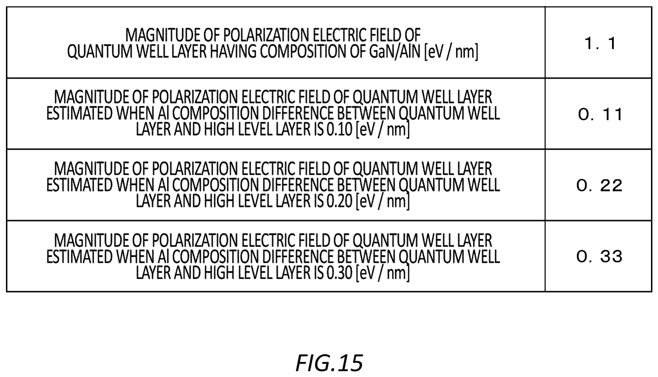

Fig. 15 is a table illustrating an example of the magnitude of the polarization electric field of the quantum well layer 110 in the LED 100 according to the first embodiment. A first row of the table of Fig. 15 shows 1.1 as the magnitude (eV/nm) of the polarization electric field of the quantum well layer having a composition of GaN/AlN. In the quantum well layer having the composition of GaN/AlN, an Al composition difference between an Al composition of GaN and an Al composition of AlN can be regarded as 1.0. Therefore, in the LED 100 according to the present embodiment, the magnitude (eV/nm) of the polarization electric field of the quantum well layer 110 may be estimated according to the Al composition difference between the quantum well layer 110 and the high level layer. A second row of the table of Fig. 15 shows 0.11 as the magnitude (eV/nm) of the polarization electric field of the quantum well layer 110 estimated when the Al composition difference is 0.10, a third row shows 0.22 as the magnitude (eV/nm) of the polarization electric field of the quantum well layer 110 estimated when the Al composition difference is 0.20, and a fourth row shows 0.33 as the magnitude (eV/nm) of the polarization electric field of the quantum well layer 110 estimated when the Al composition difference is 0.30.

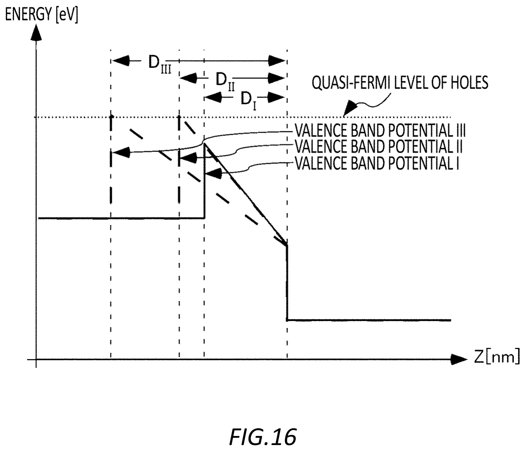

Fig. 16 is a diagram illustrating an example of a relationship between the width D of the quantum well layer 110 and the graph of the valence band potential in the LED 100 according to the first embodiment. In Fig. 16, a horizontal axis represents the position Z (nm), and a vertical axis represents the energy (eV).

Fig. 16 illustrates a graph of the valence band potential in three LEDs 100 which have a same Al composition difference between the quantum well layer 110 and the N-type contact layer 120 which is the high level layer, have a same quasi-Fermi level of holes, and have different widths D of the quantum well layer 110. Among the three LEDs 100, a graph of a valence band potential I for $D_I$, which is a smallest width of the quantum well layer 110, is indicated by a solid line, a graph of a valence band potential II for $D_{II}$, which is a second smallest width of the quantum well layer 110, is indicated by a broken line, and a graph of a valence band potential III for $D_{III}$, which is a largest width of the quantum well layer 110, is also indicated by a broken line.

First, when the graph of the valence band potential I is compared with the graph of the valence band potential II illustrated in Fig. 16, although the magnitude of the polarization electric field is the same, the graph of the valence band potential I for $D_I$, which a smaller width of the quantum well layer 110, is separated from the graph of the quasi-Fermi level of holes. On the other hand, the graph of the valence band potential II for $D_{II}$, which is a larger width of the quantum well layer 110, is in contact with the graph of the quasi-Fermi level of holes. That is, there is an energy difference between the valence band potential I and the quasi-Fermi level of holes when the width of the quantum well layer 110 is small, whereas the energy difference between the valence band potential II and the quasi-Fermi level of holes when the width of the quantum well layer 110 is large is 0.

Next, when the graph of the valence band potential II is compared with the graph of the valence band potential III illustrated in Fig. 16, both graphs are in contact with the graph of the quasi-Fermi level of holes, but differ in the magnitude of the polarization electric field. That is, both the valence band potential II and the valence band potential III have an energy difference of 0 from the quasi-Fermi level of holes, whereas the width $D_{III}$ of the quantum well layer 110 corresponding to the valence band potential III is larger than the width $D_{II}$ of the quantum well layer 110 corresponding to the valence band potential II.

As described above, when the width D of the quantum well layer 110 is increased, the spatial overlap of the above (1) is deteriorated, and the probability that electrons and holes encounter each other is reduced, but on the other hand, the number of the above (2) is increased, and the energy difference of the above (3) is reduced, so that the carrier concentration is increased, and the probability that electrons and holes encounter each other is increased. More specifically, as understood from the graph of Fig. 16, as the width D of the quantum well layer 110 is increased until an energy difference between the valence band potential and the quasi-Fermi level of holes is 0, the IQE increases due to an influence of the increase in the hole concentration due to the above (2) and (3).

However, as described above, when the width D of the quantum well layer 110 is made larger than the predetermined size, the increase in the carrier concentration due to (2) and (3) is eliminated, and the probability of encounter due to (1) only continues to decrease. More specifically, as understood from the graph of Fig. 16, when the width D of the quantum well layer 110 is increased even when the energy difference between the valence band potential and the quasi-Fermi level of holes becomes 0, the increase in the hole concentration due to the above (2) and (3) does not occur, and the IQE decreases due to an influence of the above (1).

As described above, it is understood from the graph of Fig. 16 that there exists the width D of the quantum well layer 110 that gives the local maximum value of the IQE of the LED 100. From the above, in the LED 100, the width D of the quantum well layer 110 may be a smallest value in a range of D in which an energy difference between the valence band potential or the conduction band potential of the polarization electric field existing in the quantum well layer 110 and the quasi-Fermi level of carriers existing in the quantum well layer 110 is 0. For example, the width D may be a smallest value in a range of D in which the energy difference between the valence band potential and the quasi-Fermi level of holes existing in the quantum well layer 110 is 0. For example, the width D of the quantum well layer 110 may be the width $D_{II}$ among the three widths D illustrated in Fig. 16.

As a more specific example, assuming the carrier concentration during the operation of the LED 100, the energy difference between the quasi-Fermi level of holes and the valence band potential can be about 0.4 (eV). In this case, for example, when the Al composition difference $\Delta X$ is 0.10, that is, the magnitude of the polarization electric field is 0.11 (eV/nm) (based on the table of Fig. 15), the width D of the quantum well layer 110 is about 3.6 (nm), and the energy difference between the quasi-Fermi level of holes and the valence band potential can be 0. Thus, when the Al composition difference $\Delta X$ is 0.10, the width D of the quantum well layer 110 may be set to about 3.6 (nm) in order to give the local maximum value of the IQE of the LED 100.

Note that in the example of Fig. 16, it has been described that the three LEDs 100 having different widths D of the quantum well layer 110 have the same quasi-Fermi level of holes, but the quasi-Fermi level of carriers can change according to the carrier concentration, and the quasi-Fermi level can also increase as the carrier concentration increases.

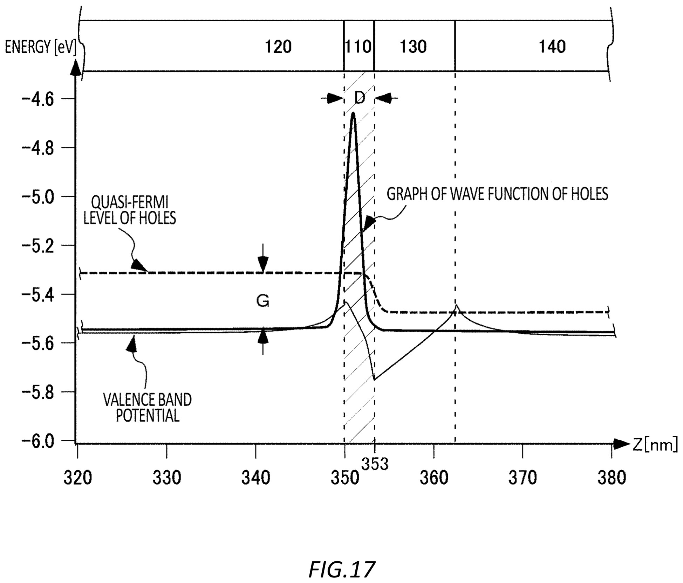

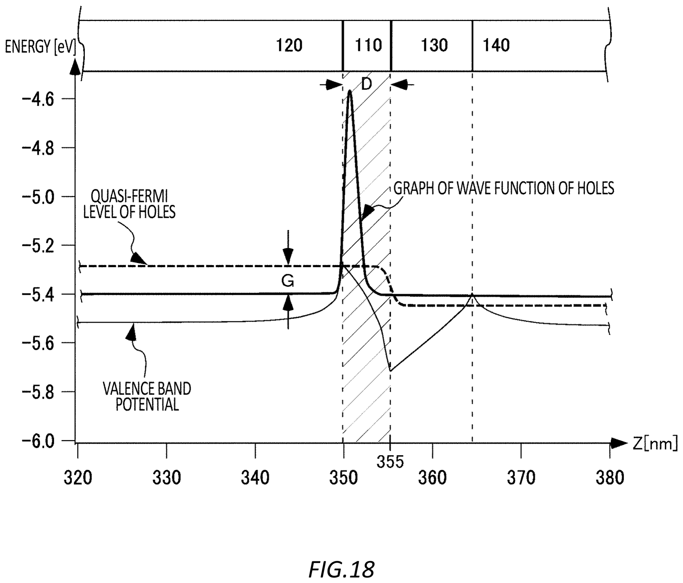

Next, an energy difference between the energy level and the quasi-Fermi level of carriers related to light emission in the above (3) will be described using Figs. 17 and 18. Fig. 17 is a diagram illustrating an example of an energy difference G between the energy level of holes and the quasi-Fermi level of holes when the Al composition difference $\Delta X$ between the high level layer and the quantum well layer is 0.10 and the width D of the quantum well layer is 3 nm in the LED according to a comparative example. Fig. 18 is a diagram illustrating an example of the energy difference G between the energy level of holes and the quasi-Fermi level of holes when the Al composition difference $\Delta X$ between the high level layer and the quantum well layer 110 is 0.10 and the width D of the quantum well layer 110 is 5 nm in the LED 100 according to the first embodiment. In Figs. 17 and 18, a range of the quantum well layer is indicated by a hatched region. In Figs. 17 and 18, a horizontal axis represents the position Z (nm), and a vertical axis represents the energy (eV).

In the LED of the comparative example illustrated in Fig. 17, the graph of the quasi-Fermi level of holes and the graph of the valence band potential are not in contact with each other. As illustrated in Fig. 17, since the energy difference between the quasi-Fermi level of holes and the valence band potential is about 0.45 (eV), when the Al composition difference $\Delta X$ is 0.10, that is, the magnitude of the polarization electric field is 0.11 (eV/nm) (based on the table of Fig. 15), the width D of the quantum well layer is about 4.1 (nm), and the energy difference between the quasi-Fermi level of holes and the valence band potential can be 0. However, in the LED according to the comparative example, since the width D of the quantum well layer is 3 nm, there is the energy difference between the quasi-Fermi level of holes and the valence band potential, and the energy difference G between the energy level of holes and the quasi-Fermi level of holes is relatively large. Therefore, the concentration of carriers contributing to light emission among carriers confined in the quantum well layer in the non-thermal equilibrium state is relatively low. In Fig. 17, a ratio at which the graph of the wave function of holes is included in the range of the quantum well layer is relatively low, that is, the number of at least one energy level of carriers related to light emission of the above (2) is relatively small. Considering the above comprehensively, it is understood that the IQE of the LED according to the comparative example does not reach its local maximum value.

On the other hand, in the LED 100 according to the first embodiment illustrated in Fig. 18, the graph of the quasi-Fermi level of holes and the graph of the valence band potential are in contact with each other. As illustrated in Fig. 18, since the energy difference between the quasi-Fermi level of holes and the valence band potential is about 0.52 (eV), when the Al composition difference ΔX is 0.10, that is, the magnitude of the polarization electric field is 0.11 (eV/nm) (based on the table of Fig. 15), the width D of the quantum well layer is about 4.7 (nm), and the energy difference between the quasi-Fermi level of holes and the valence band potential can be 0. In the LED 100 according to the first embodiment, since the width D of the quantum well layer is 5 nm, the energy difference between the quasi-Fermi level of holes and the valence band potential is 0, and the energy difference G between the energy level of holes and the quasi-Fermi level of holes is relatively small. Therefore, the concentration of carriers contributing to light emission among carriers confined in the quantum well layer in the non-thermal equilibrium state is relatively high. In Fig. 18, a ratio at which the graph of the wave function of holes is included in the range of the quantum well layer 110 is relatively high, that is, the number of at least one energy level of carriers related to the light emission of the above (2) is relatively large. Considering the above comprehensively, it is understood that the IQE of the LED 100 according to the first embodiment substantially reach its local maximum value.

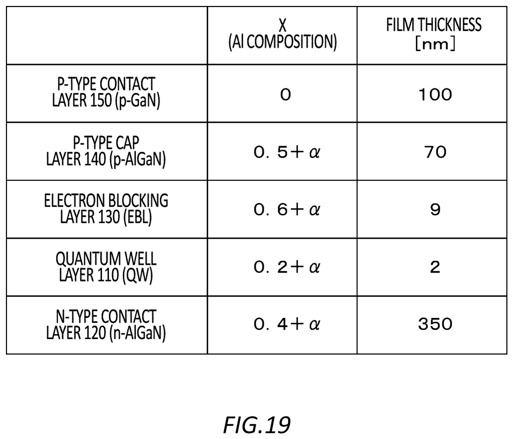

As described above, the energy difference between the quasi-Fermi level of holes and the valence band potential is determined by the Al composition difference ΔX between the quantum well layer 110 and the high level layer and the width D of the quantum well layer 110. In order to confirm this, a simulation result in which the energy difference between the quasi-Fermi level of holes and the valence band potential becomes almost constant even when the Al composition of each layer of the LED 100 is uniformly changed will be described with reference to Figs. 19 to 21.

Fig. 19 is a table illustrating a simulation example of the Al composition and the film thickness when the Al composition of each layer is uniformly changed by +α in the LED 100 according to the first embodiment. A first row of the table of Fig. 19 shows the X (Al composition) and the film thickness (nm) in order from a left side. A second row to a fifth row of the table of Fig. 19 show, in order, the X and the film thickness of the P-type contact layer 150 (p-GaN), the P-type cap layer 140 (p-AlGaN), the electron blocking layer 130 (EBL), the quantum well layer 110 (QW), and the N-type contact layer 120 (n-AlGaN).

In the simulation example illustrated in Fig. 19, the Al composition X and the film thickness of the P-type contact layer 150 are set to 0 and 100 (nm). The Al composition X(b3) and the film thickness of the P-type cap layer 140 are $0.5 + \alpha$ and 70 (nm). The Al composition X(b2) and the film thickness of the electron blocking layer 130 are $0.6 + \alpha$ and 9 (nm). The Al composition X(a) and the film thickness of the quantum well layer 110 are $0.2 + \alpha$ and 2 (nm). The Al composition X(b1) and the film thickness of the N-type contact layer 120 are $0.4 + \alpha$ and 350 (nm). In this simulation example, the Al compositions of the P-type cap layer 140, the electron blocking layer 130, the quantum well layer 110, and the N-type contact layer 120 are uniformly changed by +α (α = 0, 0.1, 0.2, 0.3, 0.4).

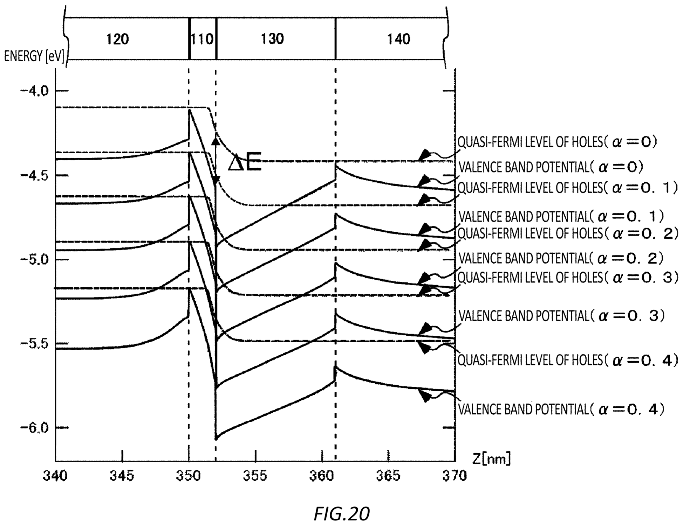

Fig. 20 is a graph illustrating simulation results of transition of the graph of the quasi-Fermi level of holes and the graph of the valence band potential when the Al composition of each layer is uniformly changed by +α according to the simulation example of Fig. 19. In Fig. 20, a horizontal axis represents the position Z (nm), and a vertical axis represents the energy (eV).

Fig. 20 illustrates the graph of the quasi-Fermi level of holes and the graph of the valence band potential for each of five patterns of α = 0, 0.1, 0.2, 0.3, and 0.4. In Fig. 20, the energy difference between the quasi-Fermi level of holes and the valence band potential is indicated by ΔE.

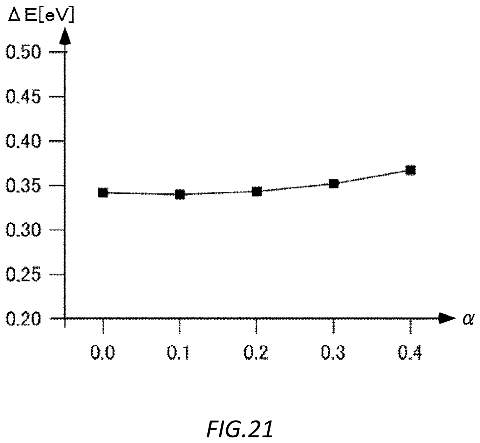

Fig. 21 is a graph illustrating a relationship between each α in Fig. 20 and an energy difference ΔE. In Fig. 21, a horizontal axis represents α, and a vertical axis represents the energy difference ΔE (eV). According to Figs. 20 and 21, it is understood that the energy difference between the quasi-Fermi level of holes and the valence band potential becomes almost constant even when the Al composition of each layer of the LED 100 is uniformly changed.

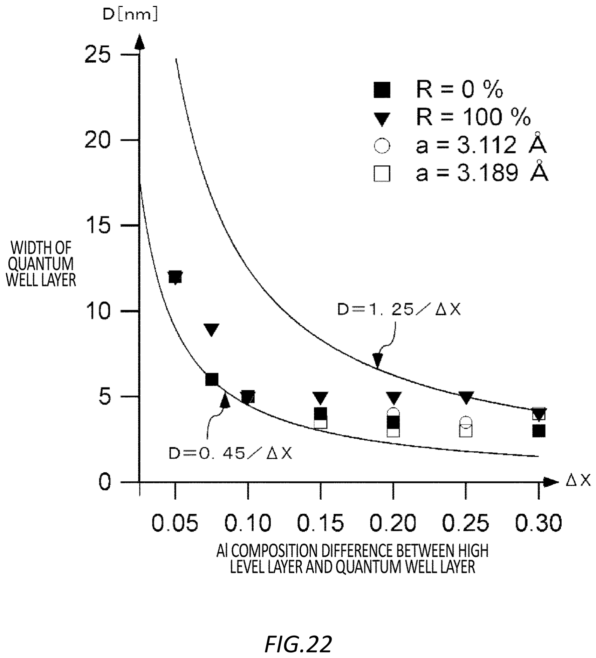

In the first simulation example and the second simulation example described above, a strain state of the quantum well layer 110 was set as coherent strain (R = 0%). Here, simulation results when the strain state of the quantum well layer 110 is made different are shown. Fig. 22 is a graph illustrating a simulation example of the relationship between the Al composition difference (ΔX) between the high level layer and the quantum well layer 110 and the width (D) of the quantum well layer 110, which changes according to an influence of an interface between the quantum well layer 110 and a layer adjacent to the quantum well layer 110, in the LED 100 according to the first embodiment. In Fig. 22, a horizontal axis represents the Al composition difference ΔX between the high level layer and the quantum well layer 110, and a vertical axis represents the width D (nm) of the quantum well layer 110.

In Fig. 22, each of a calculated value when the strain state of the quantum well layer 110 is coherent strain (R = 0%) and a calculated value when the strain state is complete relaxation (R = 100%) is plotted based on AlGaN of the N-type contact layer 120 which is the high level layer. Further, in Fig. 22, as another index of the strain state of the quantum well layer 110, each of a calculated value when a = 3.112 (Å), which is a lattice constant of AlN, is assumed as a reference lattice constant of the N-type contact layer, and a calculated value when a = 3.189 (Å), which is a lattice constant of GaN, is assumed as the reference lattice constant is plotted. The strain states of four graphs illustrated in Fig. 22 are shown in Table 1 below. a = 3.112 (Å) is a state where a strongest compressive strain is applied in the AlGaN-based LED 100, and a = 3.189 (Å) is a state where a strongest tensile strain is applied in the AlGaN-based LED 100.

(Table 1)

|  | R = 0 | R = 100 | a = 3.112 | a = 3.189 |
|---|---|---|---|---|
| QUANTUM WELL LAYER | COMPRESSION | ZERO | STRONG COMPRESSION | TENSION |
| N-TYPE CONTACT LAYER | ZERO | ZERO | COMPRESSION | STRONG TENSION |

According to the simulation result of Fig. 22, in the LED 100 according to the first embodiment, a difference between the Al composition in the quantum well layer 110 and the Al composition in the high level layer, that is, $\Delta X$ which is a difference between a and b described above, and the width D (nm) of the quantum well layer 110 satisfy following Relational Expression 1:

$$\text{(Relational Expression 1) } D = k/\Delta X$$

(where, in Relational Expression 1, D > 3, 0 < $\Delta X$ < 0.15, and $0.45 \leq k \leq 1.25$ (a unit of coefficient k is (nm))).

Each configuration and composition, and the like of the LED 100 according to the first embodiment described above are not limited to a case where the LED 100 is AlGaN-based, and may be extendable to InGaN (indium gallium nitride)-based, AlInGaN (aluminum indium gallium nitride)-based, and the like.

For example, in an InGaN-based LED, the quantum well layer 110 may have a composition of $In_{1-c}Ga_cN$ (0 < c < 1), and the high level layer may have a composition of $In_{1-d}Ga_dN$ (c < d $\leq$ 1). In this case, a difference between the Ga composition in the quantum well layer 110 and the Ga composition in the high level layer, that is, $\Delta X$ (= d - c) which is a difference between c and d described above, and the width D (nm) of the quantum well layer 110 satisfy following Relational Expression 2:

$$\text{(Relational Expression 2) } D = k/\Delta X$$

(where, in Relational Expression 2, D $\geq$ 2, 0 < $\Delta X$ $\leq$ 0.15, and $0.3 \leq k \leq 0.6$ (the unit of coefficient k is (nm))).

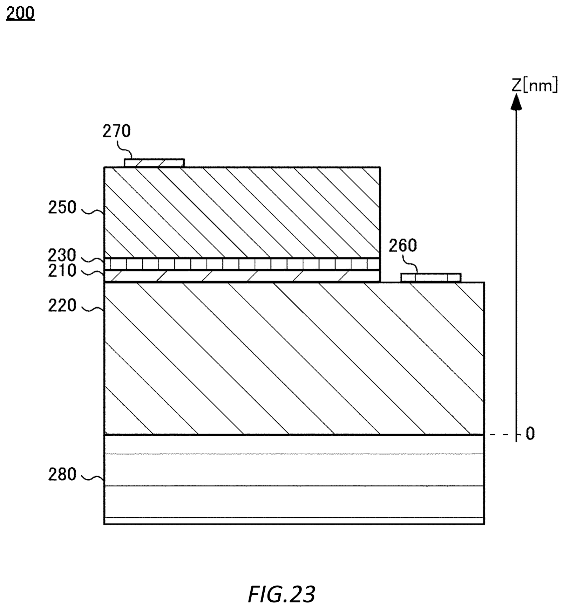

The InGaN-based LED will be described more specifically with reference to Figs. 23 to 28. Fig. 23 is a schematic view schematically illustrating an example of a structure of an LED 200 according to a second embodiment. The LED 200 according to the second embodiment includes a quantum well layer 210, an N-type contact layer 220, an electron blocking layer 230, a P-type contact layer 250, an N-layer electrode 260, a P-layer electrode 270, and a substrate 280.

As illustrated in Fig. 23, the structure of the LED 200 according to the second embodiment is different from the structure of the LED 100 according to the first embodiment in that the P-type cap layer 140 is not provided, and the P-type contact layer 250 is located on a positive Z axis side of the quantum well layer 210. A functional configuration of each layer of the LED 200 according to the second embodiment is similar to a functional configuration of a corresponding layer of the LED 100 according to the first embodiment, and same reference numerals as those of the corresponding layer of the LED 100 according to the first embodiment are used to omit redundant description.

As an example, the quantum well layer 210 has a composition of $In_{1-c}Ga_cN$ (0 < c < 1). As an example, the N-type contact layer 220 has a composition of n-$In_{1-d1}Ga_{d1}N$ (c < d1 $\leq$ 1) doped with at least one type of impurity, for example, Si. As an example, the electron blocking layer 230 has a composition of $Al_jIn_{1-d2}Ga_{d2}N$ (c < d2 $\leq$ 1, 0 < j < 1). In the LED 200 according to the second embodiment, the N-type contact layer 220 and the electron blocking layer 230 are examples of a high level layer that has a composition of $In_{1-d}Ga_dN$ (c < d $\leq$ 1), is adjacent to the quantum well layer 210, and has a higher energy level than that of the quantum well layer 210. In a case of a configuration of the LED 200 illustrated in Fig. 23, the high level layer may refer to both the N-type contact layer 220 and the electron blocking layer 230, or may refer to one of these. In addition, in the second embodiment, description "Ga composition d of the high level layer" may refer to an average of a Ga composition d1 of the N-type contact layer 220 and a Ga composition d2 of the electron blocking layer 230, or may refer to any Ga composition of these. $\Delta X$ refers to the Ga composition difference (d - c) between the Ga composition d of the high level layer and the Ga composition c of the quantum well layer 210.

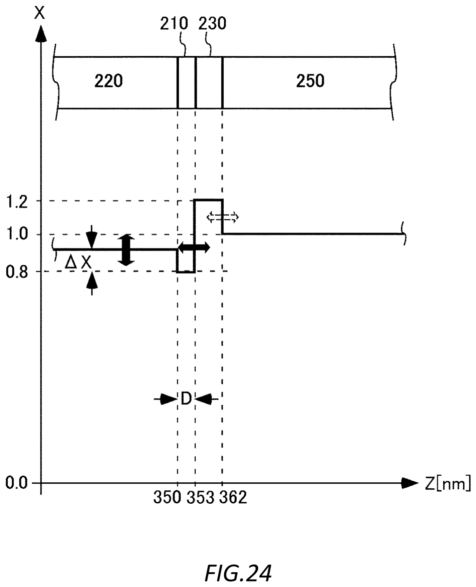

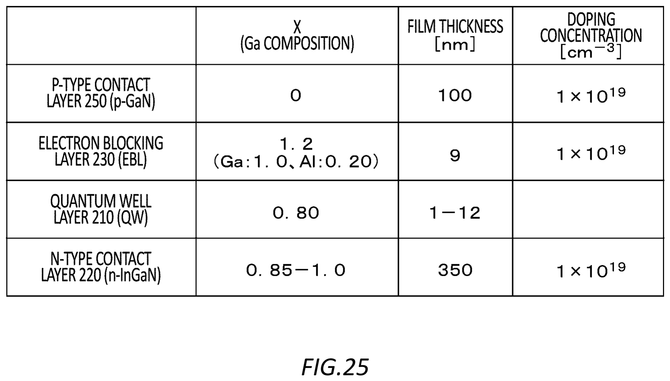

Fig. 24 is a diagram illustrating an example of the position in the Z axis direction and a Ga composition X of each layer of the LED 200 according to the second embodiment. Fig. 25 is a table illustrating a simulation example of the Ga composition X, a film thickness, and the like of each layer of the LED 200 according to the second embodiment.

A horizontal axis illustrated in Fig. 24 represents a position Z (nm) in the Z axis direction, and a vertical axis represents the Ga composition X defined in a range of 0 to 1 (0% to 100%). In the present embodiment, "X" is a generic term for "c", "d", "d1", and "d2" described above. However, the vertical axis shows exceptionally up to a range where the Ga composition X is 1.2, which corresponds to a case where the Al composition of 0.2 is added to the Ga composition X = 1. In Fig. 24, the Ga composition X in each layer of the LED 200 is shown by one continuous thick-line graph. Further, in Fig. 24, the layers existing at respective positions Z are shown in a band graph shape on an upper side of the graph.

A first row of the table of Fig. 25 shows the X (Ga composition), the film thickness (nm), and a doping concentration (cm$^{-3}$) in order from a left side. A second row to a fifth row of the table of Fig. 25 show, in order, the Ga composition X, the film thickness, and the like of the P-type contact layer 250 (p-GaN), the electron blocking layer 230 (EBL), the quantum well layer 210 (QW), and the N-type contact layer 220 (n-InGaN).

In the simulation example illustrated in Fig. 25, the Ga composition X, the film thickness, and the doping concentration of the P-type contact layer 250 are set to 0, 100 (nm), and $1\times10^{19}$ (cm$^{-3}$). The Ga composition X(d2), the film thickness, and the doping concentration of the electron blocking layer 230 are set to 1.2 (Ga: 1.0, Al: 0.20), 9 (nm), and $1\times10^{19}$ (cm$^{-3}$).

In the simulation example illustrated in Fig. 25, the Ga composition X(d1) of the N-type contact layer 220 was set to each of 0.85, 0.90, 0.95, and 0.98. The film thickness and the doping concentration of the N-type contact layer 220 are set to 350 (nm) and $1\times10^{19}$ (cm$^{-3}$). In this simulation example, the film thickness, that is, the width of the quantum well layer 210 is changed in a range of 1 to 12 (nm) in each Ga composition X(d1) of the N-type contact layer 220. The Ga composition X(c) of the quantum well layer 210 is set to 0.80. Note that when the Ga composition X(c) of the quantum well layer 210 is 0.80, the emission wavelength of the LED 200 is set to about 400 nm.

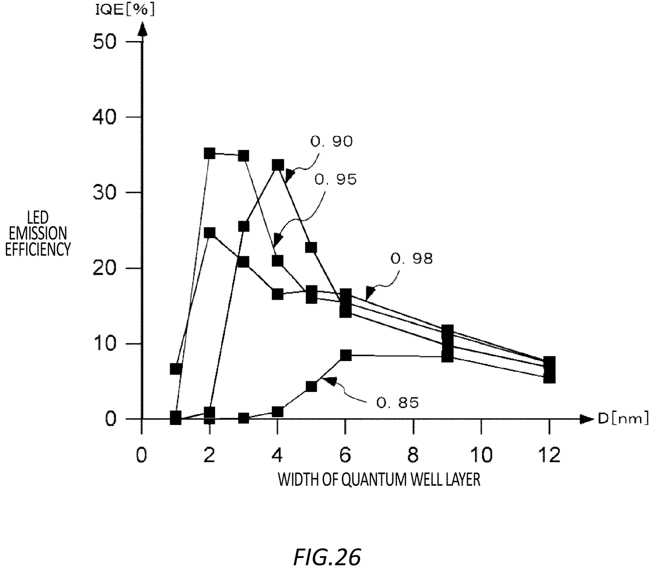

Fig. 26 is a graph illustrating a simulation result of a relationship between a width (D) of the quantum well layer 210 and the emission efficiency (IQE) according to the simulation example of Fig. 25. In Fig. 26, a horizontal axis represents the width D (nm) of the quantum well layer 210, and a vertical axis represents the emission efficiency (IQE) (%) of the LED 200.

In this simulation, it is assumed that an operating current (J) of 10 (A/cm$^2$) flows through the LED 200. Fig. 26 illustrates a graph of transition of the IQE of the LED 200 with the change in the width D of the quantum well layer 210 for a case where the Ga composition X(d1) of the N-type contact layer 220 was set to each of 0.85, 0.90, 0.95, and 0.98. Calculated values of the width D and the IQE are plotted on each graph. Note that as described with reference to Fig. 25, the width D was changed in the range of 1 to 12 (nm).

As illustrated in Fig. 26, it is understood that there exists the width D of the quantum well layer 210 that gives a local maximum value of the IQE of the LED 200, regardless of the Ga composition X(d1) of the N-type contact layer 220.

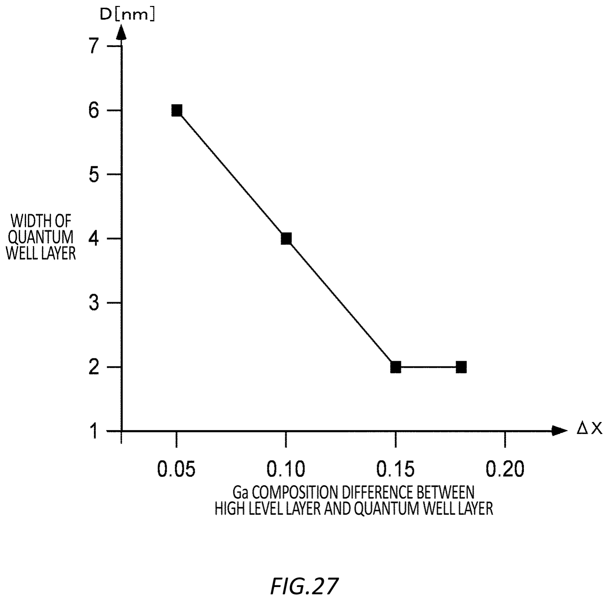

Fig. 27 is a graph illustrating a relationship between the Ga composition difference ($\Delta$X) in Fig. 26 and the width (D) of the quantum well layer 210 where the emission efficiency reaches its local maximum for each Ga composition difference ($\Delta$X). In Fig. 27, a horizontal axis represents the Ga composition difference $\Delta$X (= d1 - c) between the high level layer, that is, the N-type contact layer 220 and the quantum well layer 210, and a vertical axis represents the width D (nm) of the quantum well layer 210.

As illustrated in Fig. 27, it is understood that, in a range of $0 < \Delta X \leq 0.15$, as the Ga composition difference $\Delta$X (= d - c) between the Ga composition c of the quantum well layer 210 and the Ga composition d of the high level layer decreases, the width D of the quantum well layer 210 that gives the local maximum value of the IQE of the LED 200 increases. In other words, it is understood that, in this range, $\Delta$X (= d - c), which is the difference between the Ga composition c in the quantum well layer 210 and the Ga composition d in the high level layer, and the width D (nm) of the quantum well layer 210 that gives the local maximum value of IQE have a negative correlation. Specifically, as $\Delta$X decreases, D that gives the local maximum of the IQE increases.

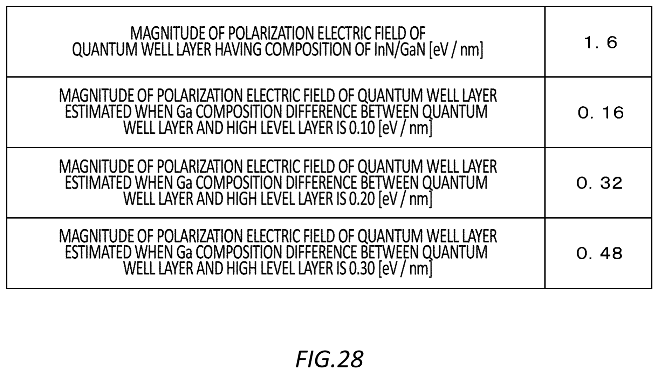

Fig. 28 is a table illustrating an example of the magnitude of the polarization electric field of the quantum well layer 210 in the LED 200 according to the second embodiment. A first row of the table of Fig. 28 shows 1.6 as the magnitude (eV/nm) of the polarization electric field of the quantum well layer having a composition of InN/GaN. In the quantum well layer having the composition of InN/GaN, a Ga composition difference between a Ga composition of InN and a Ga composition of GaN can be regarded as 1.0. Therefore, similarly to the case of the LED 100 according to the first embodiment, also in the LED 200 according to the second embodiment, the magnitude (eV/nm) of the polarization electric field of the quantum well layer 210 may be estimated according to the Al composition difference between the quantum well layer 210 and the high level layer. A second row of the table of Fig. 28 shows 0.16 as the magnitude (eV/nm) of the polarization electric field of the quantum well layer 210 estimated when the Ga composition difference is 0.10, a third row shows 0.32 as the magnitude (eV/nm) of the polarization electric field of the quantum well layer 210 estimated when the Ga composition difference is 0.20, and a fourth row shows 0.48 as the magnitude (eV/nm) of the polarization electric field of the quantum well layer 210 estimated when the Ga composition difference is 0.30.

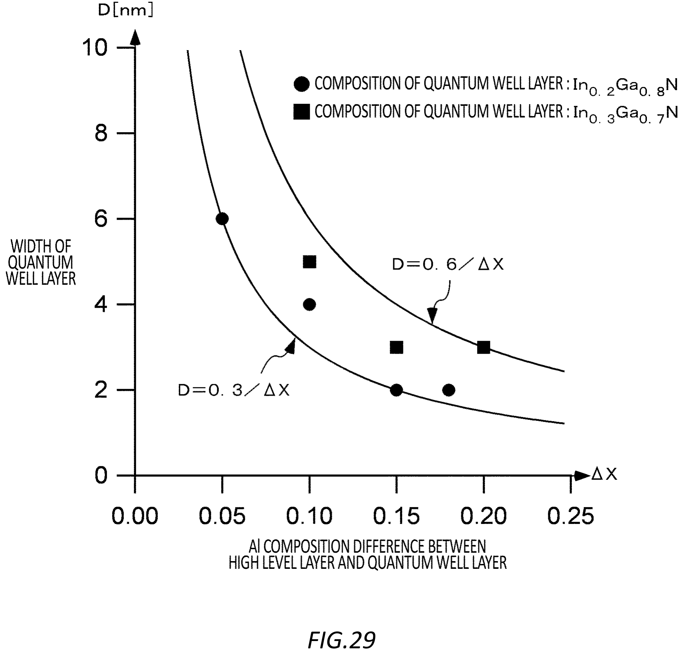

Fig. 29 is a graph illustrating a simulation example of the relationship between the Al composition difference ($\Delta$X) between the high level layer and the quantum well layer 210 and the width (D) of the quantum well layer 210 when a strain state of the quantum well layer 210 is coherent strain in the LED 200 according to the second embodiment. In Fig. 29, a horizontal axis represents the Al composition difference $\Delta$X between the high level layer and the quantum well layer 210, and a vertical axis represents the width D (nm) of the quantum well layer 210.

In Fig. 29, each of a calculated value when the quantum well layer 210 has a composition of In$_{0.2}$Ga$_{0.8}$N and a calculated value when the quantum well layer 210 has a composition of In$_{0.3}$Ga$_{0.7}$N is plotted. According to the simulation result of Fig. 29, it is understood that, in the LED 200 according to the second embodiment, a difference between the Al composition in the quantum well layer 210 and the Al composition in the high level layer, that is, $\Delta$X (= d - c) which is a difference between c and d described above, and the width D (nm) of the quantum well layer 110 satisfy following Relational Expression 2:

$$\text{(Relational Expression 2)} \quad D = k/\Delta X$$

(where, in Relational Expression 2, $D \geq 2$, $0 < \Delta X \leq 0.15$, and $0.3 \leq k \leq 0.6$ (the unit of coefficient k is (nm))).

In the plurality of embodiments described above, the quantum well layer 110, 210 is a single quantum well layer (QW layers) as an example. Alternatively, the quantum well layer 110, 210 may be a multiple quantum well layer (MQW layers). When the quantum well layer 110 according to the first embodiment is an MQW layer, at least one layer of a plurality of layers for confining carriers in the MQW layer has a composition of $Al_aGa_{1-a}N$ ($0 < a < 1$). When the quantum well layer 210 according to the second embodiment is an MQW layer, at least one layer of a plurality of layers for confining carriers in the MQW layer has a composition of $In_{1-c}Ga_cN$ ($0 < c < 1$).

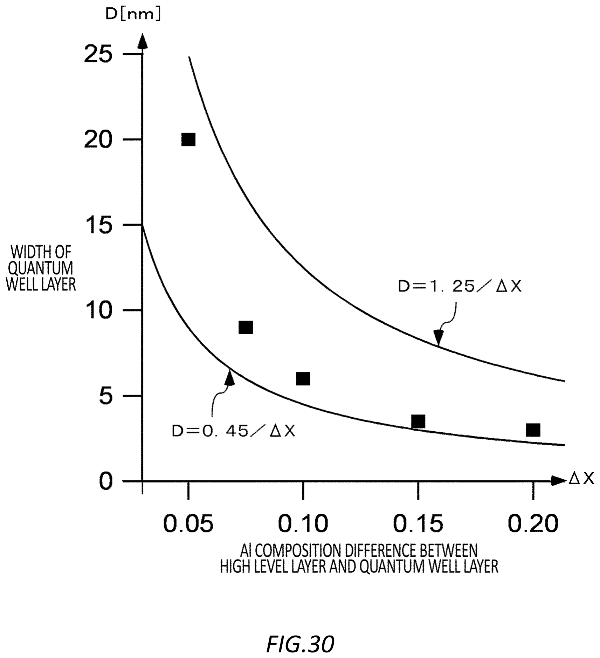

Fig. 30 is a graph illustrating a simulation example of the relationship between the Al composition difference ($\Delta X$) between the high level layer and the quantum well layer 110 and the width (D) of the quantum well layer 110 when the quantum well layer 110 of the LED 100 according to the first embodiment is a three-layer multiple quantum well layer (MQW layer) in which the strain state is coherent strain. Similarly to the graph of Fig. 22, in Fig. 30, a horizontal axis represents the Al composition difference $\Delta X$ between the high level layer and the quantum well layer 110, and a vertical axis represents the width D (nm) of the quantum well layer 110. According to the simulation result of Fig. 30, it is understood that, even when the quantum well layer 110 is, for example, a three-layer MQW layer, the difference between the Al composition in the quantum well layer 110 and the Al composition in the high level layer, that is, $\Delta X$ which is the difference between a and b described above, and the width D (nm) of the quantum well layer 110 satisfy following Relational Expression 1:

$$\text{(Relational Expression 1)} \quad D = k/\Delta X$$

(where, in Relational Expression 1, $D > 3$, $0 < \Delta X < 0.15$, and $0.45 \leq k \leq 1.25$ (the unit of coefficient k is (nm))).

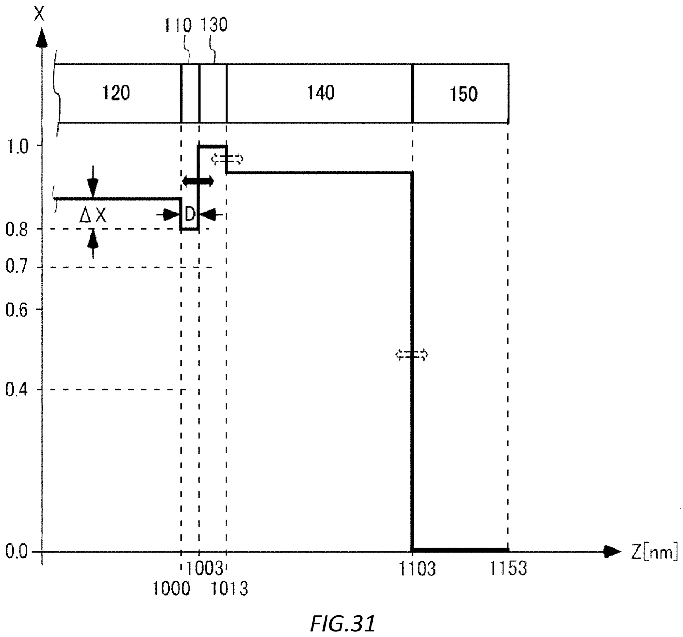

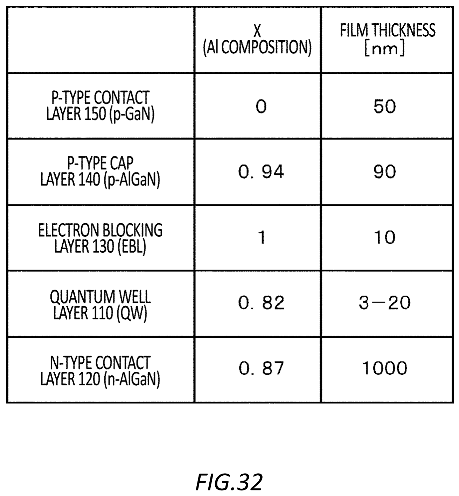

Fig. 31 is a diagram illustrating another example of the position in the Z axis direction and the Al composition X of each layer of the LED 100 according to the first embodiment. Fig. 32 is a table illustrating an experimental example of the Al composition X, the film thickness, and the like of each layer of the LED 100 according to the first embodiment.

A horizontal axis illustrated in Fig. 31 represents a position Z (nm) in the Z axis direction, and a vertical axis represents the Al composition X defined in a range of 0 to 1 (0% to 100%). In Fig. 31, the Al composition X in each layer of the LED 100 is shown by one continuous thick-line graph. Further, in Fig. 31, the layers existing at respective positions Z are shown in a band graph shape on an upper side of the graph.

A first row of the table of Fig. 32 shows the X (Al composition) and the film thickness (nm) in order from a left side. A second row to a fifth row of the table of Fig. 32 show, in order, the Al compositions X, the film thicknesses, and the like of the P-type contact layer 150 (p-GaN), the P-type cap layer 140 (p-AlGaN), the electron blocking layer 130 (EBL), the quantum well layer 110 (QW), and the N-type contact layer 120 (n-AlGaN).

In the experimental example illustrated in Fig. 32, five LEDs 100 were prepared which were different from each other in only the film thickness of the quantum well layer 110 in a range of 3 to 20 (nm). In each of the five LEDs 100, the Al composition X(a) of the quantum well layer 110 was set to 0.82, the Al composition X and the film thickness of the P-type contact layer 150 were set to 0 and 50 (nm), and the Al composition X(b3) and the film thickness of the P-type cap layer 140 were set to 0.94 and 90 (nm). In addition, the Al composition X(b2) and the film thickness of the electron blocking layer 130 were set to 1 and 10 (nm), and the Al composition X(b1) and the film thickness of the N-type contact layer 120 were set to 0.87 and 1000 (nm).

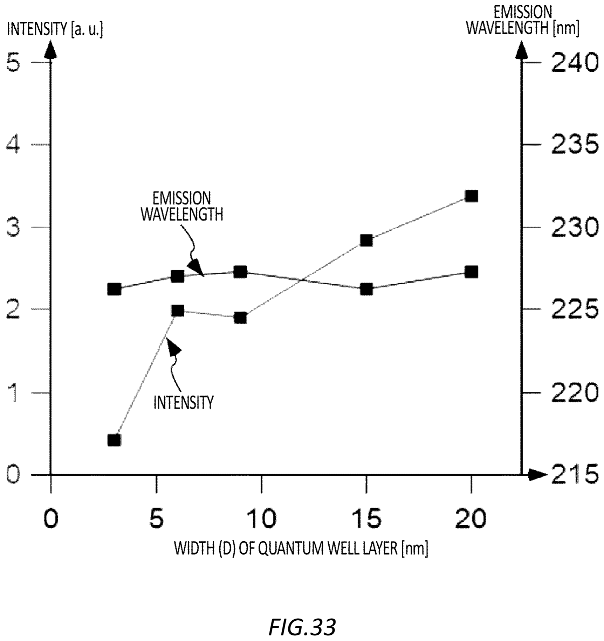

Fig. 33 is a graph illustrating experimental results of a relationship among the width (D) of the quantum well layer 110, the emission wavelength, and an intensity according to the experimental example of Fig. 32. In Fig. 33, a horizontal axis represents the width D (nm) of the quantum well layer 110, a vertical axis on a right side represents the emission wavelength (nm) of the LED 100, and a vertical axis on a left side represents the intensity (a.u) of light emission of the LED 100.

In the present experimental example, a current of 20 mA was passed through each LED 100, and the emission wavelength and the emission intensity of each LED 100 were measured. As illustrated in the graph of Fig. 33, the experimental result was obtained in which, even when the width D of the quantum well layer 110 of the LED 100, that is, the film thickness changes in the range of 3 to 20 (nm), the emission wavelength (nm) is almost constant regardless of the film thickness. In addition, an experimental result was also obtained in which the emission intensity increases almost monotonically as the film thickness of the quantum well layer 110 of the LED 100 increases in the range of 3 to 20 (nm). The experimental result illustrated in Fig. 33 is close to a behavior in the simulation result when the Al composition difference between the N-type contact layer 120 and the quantum well layer 110 is set to 0.05 similarly to the present experimental example, and it is understood that a calculation in the simulation and the experimental result are consistent with each other.

In the plurality of embodiments described above, the LED 100, 200 may include a light emitting layer including a well layer and a barrier layer instead of the quantum well layer 110, 210, and an Al composition of the well layer may be lower than an Al composition of the barrier layer. The light emitting layer may have a multiple quantum well structure including a plurality of sets of a well layer and a barrier layer, and in this case, an Al composition of each of the well layer and the barrier layer may differ for each of the sets. That is, the Al composition of the well layer may differ for each well, and the Al composition of the barrier layer may differ for each barrier. In any of these cases, a side of the light emitting layer closest to the N-type contact layer 120, 220 may be a well layer or a barrier layer. Similarly, a side of the light emitting layer closest to the electron blocking layer 130, 230 may be a well layer or a barrier layer.

While the embodiments of the present invention have been described, the technical scope of the present invention is not limited to the above-described embodiments. It is apparent to persons skilled in the art that various alterations or improvements can be added to the above-described embodiments. It is also apparent from the described scope of the claims that the embodiments added with such alterations or improvements can be included the technical scope of the present invention.

Note that the operations, procedures, steps, stages, or the like of each process performed by a device, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

EXPLANATION OF REFERENCES

100: LED;

110: quantum well layer;

120: N-type contact layer;

130: electron blocking layer;

140: P-type cap layer;

150: P-type contact layer;

160: N-layer electrode;

170: P-layer electrode;

180: substrate;

200: LED;

210: quantum well layer;

220: N-type contact layer;

230: electron blocking layer;

250: P-type contact layer;

260: N-layer electrode;

270: P-layer electrode;

280: substrate.

**Claims**

1. An LED which has a quantum well structure, comprising:

   a quantum well layer which has a composition of $Al_aGa_{1-a}N$ (aluminum gallium nitride) (0 < a < 1); and
   a high level layer which has a composition of $Al_bGa_{1-b}N$ (a < b ≤ 1), is adjacent to the quantum well layer, and has a higher energy level than that of the quantum well layer, wherein
   ΔX, which is a difference between the a and the b, and a width D (nm) of the quantum well layer satisfy following Relational Expression 1:

$$(\text{Relational Expression 1}) \ D = k/\Delta X$$

   (where, in Relational Expression **1**, D > 3, 0 < ΔX < 0.15, and 0.45 ≤ k ≤ 1.25 (a unit of coefficient k is (nm))).

2. The LED according to claim 1, wherein
   the D is a smallest value in a range of the D in which an energy difference between a valence band potential or a conduction band potential of a polarization electric field existing in the quantum well layer and a quasi-Fermi level of carriers existing in the quantum well layer is 0.

3. The LED according to claim 2, wherein
   the D is a smallest value in a range of the D in which an energy difference between the valence band potential and a quasi-Fermi level of holes existing in the quantum well layer is 0.

4. An LED which has a quantum well structure, comprising:

   a quantum well layer which has a composition of $In_{1-c}Ga_cN$ (indium gallium nitride) (0 < c < 1); and
   a high level layer which has a composition of $In_{1-d}Ga_dN$ (c < d ≤ 1), is adjacent to the quantum well layer, and has a higher energy level than that of the quantum well layer, wherein
   ΔX, which is a difference between the c and the d, and a width D (nm) of the quantum well layer satisfy following Relational Expression 2:

$$(\text{Relational Expression 2}) \ D = k/\Delta X$$

   (where, in Relational Expression 2, D ≥ 2, 0 < ΔX ≤ 0.15, and 0.3 ≤ k ≤ 0.6 (a unit of coefficient k is (nm))).

5. The LED according to claim 4, wherein
   the D is a smallest value in a range of the D in which an energy difference between a valence band potential or a conduction band potential of a polarization electric field existing in the quantum well layer and a quasi-Fermi level of carriers existing in the quantum well layer is 0.

6. The LED according to claim 5, wherein
   the D is a smallest value in a range of the D in which an energy difference between the valence band potential and a quasi-Fermi level of holes existing in the quantum well layer is 0.

7. An LED manufacturing method for an LED which has a quantum well structure, the LED manufacturing method comprising:

   forming a quantum well layer which has a composition of $Al_aGa_{1-a}N$ (aluminum gallium nitride) (0 < a < 1); and
   forming a high level layer which has a composition of $Al_bGa_{1-b}N$ (a < b ≤ 1), is adjacent to the quantum well layer, and has a higher energy level than that of the quantum well layer, wherein
   ΔX, which is a difference between the a and the b, and a width D (nm) of the quantum well layer satisfy following Relational Expression 1:

$$(\text{Relational Expression 1}) \ D = k/\Delta X$$

   (where, in Relational Expression 1, D > 3, 0 < ΔX < 0.15, and 0.45 ≤ k ≤ 1.25 (a unit of coefficient k is (nm))).

8. An LED manufacturing method for an LED which has a quantum well structure, the LED manufacturing method comprising:

forming a quantum well layer which has a composition of $In_{1-c}Ga_cN$ (indium gallium nitride) ($0 < c < 1$); and
forming a high level layer which has a composition of $In_{1-d}Ga_dN$ ($c < d \leq 1$), is adjacent to the quantum well layer, and has a higher energy level than that of the quantum well layer, wherein
$\Delta X$, which is a difference between the c and the d, and a width D (nm) of the quantum well layer satisfy following Relational Expression 2:

$$\text{(Relational Expression 2)} \quad D = k/\Delta X$$

(where, in Relational Expression 2, $D \geq 2$, $0 < \Delta X \leq 0.15$, and $0.3 \leq k \leq 0.6$ (a unit of coefficient k is (nm))).

100

170

150

140

130
110

120

180

160

Z[nm]

0

FIG.1

*FIG.2*

|  | X<br>(Al COMPOSITION) | FILM THICKNESS<br>[nm] | DOPING<br>CONCENTRATION<br>$[\text{cm}^{-3}]$ |
|---|---|---|---|
| P-TYPE CONTACT<br>LAYER 150 (p-GaN) | 0 | 100 | $1 \times 10^{19}$ |
| P-TYPE CAP<br>LAYER 140 (p-AlGaN) | 0. 70 | 70 | $1 \times 10^{19}$ |
| ELECTRON BLOCKING<br>LAYER 130 (EBL) | 0. 80 | 9 | |
| QUANTUM WELL<br>LAYER 110 (QW) | 0. 40 | 1－30 | |
| N-TYPE CONTACT<br>LAYER 120 (n-AlGaN) | 0. 45－0. 70 | 350 | $1 \times 10^{19}$ |

*FIG.3*

FIG.4

FIG.5

FIG.6

| | X (Al COMPOSITION) | FILM THICKNESS [nm] | DOPING CONCENTRATION [cm$^{-3}$] |
|---|---|---|---|
| P-TYPE CONTACT LAYER 150 (p-GaN) | 0 | 100 | $1 \times 10^{19}$ |
| P-TYPE CAP LAYER 140 (p-AlGaN) | 0.95 | 70 | $1 \times 10^{19}$ |
| ELECTRON BLOCKING LAYER 130 (EBL) | 1 | 9 | |
| QUANTUM WELL LAYER 110 (QW) | 0.70−0.86 | 1−30 | |
| N-TYPE CONTACT LAYER 120 (n-AlGaN) | 0.88 | 350 | $1 \times 10^{19}$ |

*FIG.7*

FIG.8

FIG.9

FIG.10

FIG.11

FIG.12

*FIG.13*

EP 4 746 645 A1

FIG.14

32

| MAGNITUDE OF POLARIZATION ELECTRIC FIELD OF QUANTUM WELL LAYER HAVING COMPOSITION OF GaN/AlN [eV / nm] | 1. 1 |
|---|---|
| MAGNITUDE OF POLARIZATION ELECTRIC FIELD OF QUANTUM WELL LAYER ESTIMATED WHEN Al COMPOSITION DIFFERENCE BETWEEN QUANTUM WELL LAYER AND HIGH LEVEL LAYER IS 0.10 [eV / nm] | O. 11 |
| MAGNITUDE OF POLARIZATION ELECTRIC FIELD OF QUANTUM WELL LAYER ESTIMATED WHEN Al COMPOSITION DIFFERENCE BETWEEN QUANTUM WELL LAYER AND HIGH LEVEL LAYER IS 0.20 [eV / nm] | O. 22 |
| MAGNITUDE OF POLARIZATION ELECTRIC FIELD OF QUANTUM WELL LAYER ESTIMATED WHEN Al COMPOSITION DIFFERENCE BETWEEN QUANTUM WELL LAYER AND HIGH LEVEL LAYER IS 0.30 [eV / nm] | O. 33 |

*FIG.15*

FIG.16

*FIG.17*

*FIG.18*

| | X<br>(Al COMPOSITION) | FILM THICKNESS<br>[nm] |
|---|---|---|
| P-TYPE CONTACT<br>LAYER 150 (p-GaN) | 0 | 100 |
| P-TYPE CAP<br>LAYER 140 (p-AlGaN) | $0.5 + \alpha$ | 70 |
| ELECTRON BLOCKING<br>LAYER 130 (EBL) | $0.6 + \alpha$ | 9 |
| QUANTUM WELL<br>LAYER 110 (QW) | $0.2 + \alpha$ | 2 |
| N-TYPE CONTACT<br>LAYER 120 (n-AlGaN) | $0.4 + \alpha$ | 350 |

*FIG.19*

EP 4 746 645 A1

FIG.20

38

FIG.21

FIG.22

200

FIG.23

*FIG.24*

| | X (Ga COMPOSITION) | FILM THICKNESS [nm] | DOPING CONCENTRATION [cm$^{-3}$] |
|---|---|---|---|
| P-TYPE CONTACT LAYER 250 (p-GaN) | 0 | 100 | $1 \times 10^{19}$ |
| ELECTRON BLOCKING LAYER 230 (EBL) | 1.2 (Ga:1.0、Al:0.20) | 9 | $1 \times 10^{19}$ |
| QUANTUM WELL LAYER 210 (QW) | 0.80 | 1−12 | |
| N-TYPE CONTACT LAYER 220 (n-InGaN) | 0.85−1.0 | 350 | $1 \times 10^{19}$ |

*FIG.25*

*FIG.26*

FIG.27

| MAGNITUDE OF POLARIZATION ELECTRIC FIELD OF QUANTUM WELL LAYER HAVING COMPOSITION OF InN/GaN [eV / nm] | 1. 6 |
|---|---|
| MAGNITUDE OF POLARIZATION ELECTRIC FIELD OF QUANTUM WELL LAYER ESTIMATED WHEN Ga COMPOSITION DIFFERENCE BETWEEN QUANTUM WELL LAYER AND HIGH LEVEL LAYER IS 0.10 [eV / nm] | 0. 16 |
| MAGNITUDE OF POLARIZATION ELECTRIC FIELD OF QUANTUM WELL LAYER ESTIMATED WHEN Ga COMPOSITION DIFFERENCE BETWEEN QUANTUM WELL LAYER AND HIGH LEVEL LAYER IS 0.20 [eV / nm] | 0. 32 |
| MAGNITUDE OF POLARIZATION ELECTRIC FIELD OF QUANTUM WELL LAYER ESTIMATED WHEN Ga COMPOSITION DIFFERENCE BETWEEN QUANTUM WELL LAYER AND HIGH LEVEL LAYER IS 0.30 [eV / nm] | 0. 48 |

*FIG.28*

D[nm]

WIDTH OF QUANTUM WELL LAYER

● COMPOSITION OF QUANTUM WELL LAYER : $In_{0.2}Ga_{0.8}N$
■ COMPOSITION OF QUANTUM WELL LAYER : $In_{0.3}Ga_{0.7}N$

$D = 0.6 / \Delta X$

$D = 0.3 / \Delta X$

$\Delta X$

AI COMPOSITION DIFFERENCE BETWEEN
HIGH LEVEL LAYER AND QUANTUM WELL LAYER

FIG.29

FIG.30

FIG.31

| | X<br>(Al COMPOSITION) | FILM THICKNESS<br>[nm] |
|---|---|---|
| P-TYPE CONTACT<br>LAYER 150 (p-GaN) | 0 | 50 |
| P-TYPE CAP<br>LAYER 140 (p-AlGaN) | 0. 94 | 90 |
| ELECTRON BLOCKING<br>LAYER 130 (EBL) | 1 | 10 |
| QUANTUM WELL<br>LAYER 110 (QW) | 0. 82 | 3－20 |
| N-TYPE CONTACT<br>LAYER 120 (n-AlGaN) | 0. 87 | 1000 |

*FIG.32*

FIG.33

## INTERNATIONAL SEARCH REPORT

| | International application No. |
|---|---|
| | **PCT/JP2024/026161** |

**A. CLASSIFICATION OF SUBJECT MATTER**

*H01L 33/06*(2010.01)i; *H01L 33/14*(2010.01)i; *H01L 33/32*(2010.01)i; *H01S 5/343*(2006.01)i
FI: H01L33/06; H01L33/14; H01L33/32; H01S5/343 610

According to International Patent Classification (IPC) or to both national classification and IPC

**B. FIELDS SEARCHED**

Minimum documentation searched (classification system followed by classification symbols)

H01L33/00-33/64; H01S5/00-5/50

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2017/057149 A1 (NICHIA CORPORATION) 06 April 2017 (2017-04-06) paragraphs [0038], [0045]-[0062], fig. 1 | 1, 7 |
| Y | | 2-3 |
| X | JP 9-153645 A (TOYODA GOSEI CO., LTD.) 10 June 1997 (1997-06-10) paragraphs [0015]-[0032], fig. 1-2 | 1, 7 |
| Y | | 2-3 |
| X | JP 2000-91705 A (NEC CORPORATION) 31 March 2000 (2000-03-31) paragraphs [0018]-[0019], fig. 1 | 4, 8 |
| Y | | 5-6 |
| X | WO 2016/002419 A1 (SHARP KABUSHIKI KAISHA) 07 January 2016 (2016-01-07) paragraphs [0111]-[0132], fig. 3 | 4, 8 |
| Y | | 5-6 |

☑ Further documents are listed in the continuation of Box C.　　☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **08 August 2024** | **20 August 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

| International application No. |
|---|
| **PCT/JP2024/026161** |

### C.    DOCUMENTS CONSIDERED TO BE RELEVANT

| Category* | Citation of document, with indication, where appropriate, of the relevant passages | Relevant to claim No. |
|---|---|---|
| X | US 2021/0334438 A1 (PURDUE RESERCH FOUNDATION) 28 October 2021 (2021-10-28) paragraphs [0032], [0055], fig. 2 | 4, 8 |
| Y |  | 5-6 |
| Y | WO 2007/026767 A1 (KYOTO UNIVERSITY) 08 March 2007 (2007-03-08) paragraphs [0002]-[0005], [0042]-[0052], fig. 1-4 | 2-3, 5-6 |
| Y | JP 2017-85035 A (RIKEN) 18 May 2017 (2017-05-18) paragraphs [0002], [0016]-[0029], fig. 1-5 | 2-3, 5-6 |
| A | WO 2021/260529 A1 (KING ABDULLAH UNIVERSITY OF SCIENCE AND TECHNOLOGY) 30 December 2021 (2021-12-30) entire text, all drawings | 1-8 |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| WO | 2017/057149 | A1 | 06 April 2017 | US | 2018/0287014 | A1 | |
| | | | | paragraphs [0073]-[0076], [0088]-[0111], fig. 1 | | | |
| | | | | US | 2019/0371968 | A1 | |
| | | | | CN | 108028300 | A | |
| | | | | KR | 10-2018-0082424 | A | |
| JP | 9-153645 | A | 10 June 1997 | KR | 10-0532650 | B1 | |
| | | | | KR | 10-0532651 | B1 | |
| | | | | KR | 10-0571300 | B1 | |
| JP | 2000-91705 | A | 31 March 2000 | (Family: none) | | | |
| WO | 2016/002419 | A1 | 07 January 2016 | US | 2017/0125632 | A1 | |
| | | | | paragraphs [0122]-[0143], fig. 3 | | | |
| US | 2021/0334438 | A1 | 28 October 2021 | US | 2018/0336302 | A1 | |
| WO | 2007/026767 | A1 | 08 March 2007 | (Family: none) | | | |
| JP | 2017-85035 | A | 18 May 2017 | US | 2018/0331250 | A1 | |
| | | | | paragraphs [0002], [0023]-[0037], fig. 1-5 | | | |
| | | | | WO | 2017/073046 | A1 | |
| | | | | EP | 3370268 | A1 | |
| WO | 2021/260529 | A1 | 30 December 2021 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2016511938 W

### Non-patent literature cited in the description

- **HIDEKI HIRAYAMA** ; **YASUSHI ENOMOTO** ; **ATSUHIRO KINOSHITA** ; **AKIRA HIRATA** ; **YOSHINOBU AOYAGI**. Optical Properties of AlGaN Quantum Well Structures. *MRS Internet Journal of Nitride Semiconductor Research*, 2000, vol. 5, 696-702